# EUROPEAN PATENT APPLICATION

(11) **EP 3 029 524 A1**
(43) Date of publication of application: **08.06.2016**
(21) Application number: 14832692.9
(22) Date of filing: 09.07.2014
(51) Int. Cl.: G03F 7/039, C08F 220/10, G03F 7/004, H01L 21/027

(54) **RADIATION-SENSITIVE RESIN COMPOSITION, RESIST PATTERN FORMATION METHOD, POLYMER, AND COMPOUND**

(30) Priority: 31.07.2013 JP 2013159996
(71) Applicant: JSR Corporation, Minato-ku Tokyo 105-8640 (JP)
(72) Inventor: ASANO Yusuke, Tokyo 105-8640 (JP); MOCHIDA Kenji, Tokyo 105-8640 (JP)
(74) Representative: TBK
(86) International application number: PCT/JP2014/068367
(87) International publication number: WO 2015/016027

(57) **Abstract**

A radiation-sensitive resin composition is provided containing a first polymer having a first structural unit represented by the following formula (1), and a radiation-sensitive acid generator. In the following formula (1), Z¹ to Z⁴ each independently represent a hydrogen atom, a fluorine atom, a monovalent hydrocarbon group, a monovalent fluorinated hydrocarbon group, or a monovalent group that contains a hetero atom having a valency of no less than 2; R³ represents a monovalent hydrocarbon group or a monovalent fluorinated hydrocarbon group, wherein at least any one of Z¹, Z² and R³ contains a fluorine atom, and wherein at least any one of Z¹ to Z⁴, the ring structure (a) and the ring structure (b) contains a hetero atom having a valency of no less than 2.

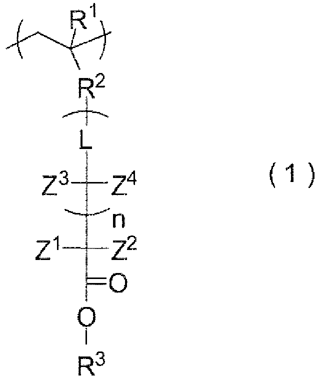

## Description

### [TECHNICAL FIELD]

The present invention relates to a radiation-sensitive resin composition, a resist pattern-forming method, a polymer and a compound.

### [BACKGROUND ART]

Miniaturization of various types of electronic device structures such as semiconductor devices and liquid crystal devices has been accompanied by demands for further microfabrication of resist patterns in lithography processes, and thus a variety of radiation-sensitive resin compositions have been studied. Such radiation-sensitive resin compositions generate at light-exposed sites an acid upon irradiation with a radioactive ray such as e.g., a far ultraviolet ray such as an ArF excimer laser, or an electron beam to produce a difference in a rate of dissolution in a developer solution between the light-exposed sites and light-unexposed sites through a catalytic action of the acid, thereby allowing a resist pattern to be formed on a substrate.

In connection with such radiation-sensitive resin compositions, as a method for forming a still finer resist pattern having, for example, a line width of about 45 nm, a liquid immersion lithography process has been employed. In this process, an exposure is carried out under a condition in which a light path space for the exposure (between a lens and a resist film) is filled with a liquid immersion medium such as e.g., pure water or a fluorine-based inert liquid, etc., having a refractive index (n) greater as compared with that of the air or an inert gas. Therefore, it is advantageous in that even in a case in which a numerical aperture (NA) of a lens is increased, the depth of focus is less likely to be decreased, and a high resolution can be attained.

In the resin composition used in the liquid immersion lithography process, a water repellent polymer additive that includes a fluorine atom-containing polymer is used for the purpose of increasing the hydrophobicity of the surface of a formed resist film in order to inhibit the elution of an acid generating agent into a liquid immersion medium from the formed resist film, to prevent the resist film from deterioration of the performances, to prevent the apparatus such as lens from getting dirty, and to improve a water draining property of the surface of the resist film such that remanence of the water mark is inhibited so as to enable high-speed scanning (see PCT International Publication No. 2007/116664). However, an increase of the hydrophobicity of the surface of a resist film leads to a decrease of surface wettability for a developer solution as well as a for a rinse agent, and therefore, development residues deposited on the light-unexposed site of the surface of the resist film during the development may be insufficiently removed, whereby defects such as blob defects may be generated on the resist pattern. For the purpose of inhibiting the generation of such defects, a fluorine atom-containing polymer that is hydrophobic during the liquid immersion lithography, but exhibits hydrophilicity during a development with an alkali, specifically, a polymer having an introduced fluoroalkyl ester structure of a carboxylic acid was proposed (see Japanese Unexamined Patent Application, Publication No. 2010-32994), and use of such a polymer as a water repellent polymer additive reportedly enables generation of defects to be inhibited.

However, at present when microfabrication of the resist pattern has proceeded to a level for a line width of no greater than 45 nm, demanded levels for the inhibitory ability of defects have further raised. In addition, the water repellent polymer additive is also expected to enable a highly accurate pattern to be obtained with a high process yield through improving a LWR (Line Width Roughness) performance and a CDU (Critical Dimension Uniformity) performance, and further an EL (Exposure Latitude) performance of a radiation-sensitive resin composition containing the water repellent polymer additive, and further. However, the conventional radiation-sensitive resin compositions still fail to meet these demands.

### [PRIOR ART DOCUMENTS]

### [PATENT DOCUMENTS]

Patent Document 1: PCT International Publication No. 2007/116664
Patent Document 2: Japanese Unexamined Patent Application, Publication No. 2010-32994

### [SUMMARY OF THE INVENTION]

### [PROBLEMS TO BE SOLVED BY THE INVENTION]

The present invention was made in view of the foregoing circumstances, and an object of the invention is to provide a radiation-sensitive resin composition that is superior in an LWR performance, a CDU performance, an EL performance and an inhibitory ability of defects.

### [MEANS FOR SOLVING THE PROBLEMS]

According to an aspect of the invention made for solving the aforementioned problems, a radiation-sensitive resin composition contains a first polymer (hereinafter, may be also referred to as "(A) polymer" or "polymer (A)") having a first structural unit represented by the following formula (1) (hereinafter, may be also referred to as "structural unit (I)"), and a radiation-sensitive acid generator (hereinafter, may be also referred to as "(B) acid generator" or "acid generator (B)"), 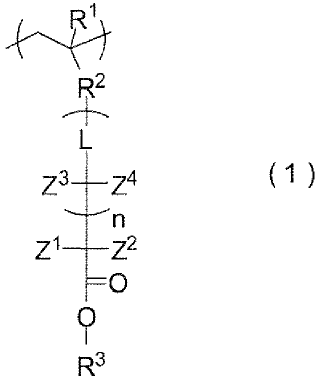 wherein, in the formula (1), R¹ represents a hydrogen atom, a fluorine atom, a methyl group or a trifluoromethyl group; R² represents a divalent linking group; Z¹ to Z⁴ each independently represent a hydrogen atom, a fluorine atom, a monovalent hydrocarbon group, a monovalent fluorinated hydrocarbon group, or a monovalent group that contains a hetero atom having a valency of no less than 2; L represents a single bond or a divalent hydrocarbon group, wherein at least two of Z³, Z⁴ and L may taken together represent a ring structure (a) having 3 to 20 ring atoms together with the carbon atom to which the at least two of Z³, Z⁴ and L bond, and wherein at least two of Z¹ to Z⁴ and L may taken together represent a ring structure (b) having 3 to 8 ring atoms together with the carbon atom to which the at least two of Z¹ to Z⁴ and L bond; n is 0 or 1; and R³ represents a monovalent hydrocarbon group or a monovalent fluorinated hydrocarbon group, wherein at least any one of Z¹, Z² and R³ contains a fluorine atom, and wherein at least any one of Z¹ to Z⁴, the ring structure (a) and the ring structure (b) contains a hetero atom having a valency of no less than 2, and in a case in which R² represents -COO- and n is 0, both Z¹ and Z² do not represent an alkoxy group.

According to another aspect of the invention made for solving the aforementioned problems, a resist pattern-forming method includes the steps of: forming a resist film; subjecting the resist film to liquid immersion lithography; and developing the resist film subjected to the liquid immersion lithography, wherein the resist film is formed from the aforementioned radiation-sensitive resin composition.

According to still another aspect of the invention made for solving the aforementioned problems, a polymer has the structural unit represented by the above formula (1).

According to yet another aspect of the invention made for solving the aforementioned problems, a compound is represented by the following formula (i): 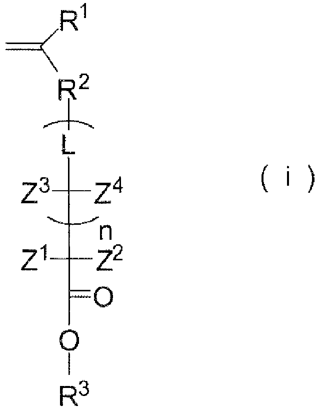 wherein, in the formula (i), R¹ represents a hydrogen atom, a fluorine atom, a methyl group or a trifluoromethyl group; R² represents a divalent linking group; Z¹ to Z⁴ each independently represent a hydrogen atom, a fluorine atom, a monovalent hydrocarbon group, a monovalent fluorinated hydrocarbon group, or a monovalent group that contains a hetero atom having a valency of no less than 2; L represents a single bond or a divalent hydrocarbon group, wherein at least two of Z³, Z⁴ and L may taken together represent a ring structure (a) having 3 to 20 ring atoms constituted together with the carbon atom to which the at least two of Z³, Z⁴ and L bond, and wherein at least two of Z¹ to Z⁴ and L may taken together represent a ring structure (b) having 3 to 8 ring atoms together with the carbon atom to which the at least two of Z¹ to Z⁴ bond; n is 0 or 1; and R³ represents a monovalent hydrocarbon group or a monovalent fluorinated hydrocarbon group, wherein at least any one of Z¹, Z² and R³ contains a fluorine atom, and wherein at least any one of Z¹ to Z⁴, the ring structure (a) and the ring structure (b) contains a hetero atom having a valency of no less than 2, and in a case in which R² represents -COO- and n is 0, both Z¹ and Z² do not represent an alkoxy group.

The "hydrocarbon group" as referred to herein may include a chain hydrocarbon group, an alicyclic hydrocarbon group and an aromatic hydrocarbon group. The "hydrocarbon group" may be either a saturated hydrocarbon group or an unsaturated hydrocarbon group. The "chain hydrocarbon group" refers to a hydrocarbon group that is constituted with only a chain structure without containing a cyclic structure, and the "chain hydrocarbon group" may include both a linear chain hydrocarbon group and a branched hydrocarbon group. The "alicyclic hydrocarbon group" as referred to means a hydrocarbon group containing as a ring structure not an aromatic ring structure but only an alicyclic structure, and the "alicyclic hydrocarbon group" contains both a monocyclic alicyclic hydrocarbon group and a polycyclic alicyclic hydrocarbon group. However, it is not necessary to be constituted with only an alicyclic structure, and a part thereof may contain a chain structure. The "aromatic hydrocarbon group" as referred to means a hydrocarbon group containing an aromatic ring structure as a ring structure. However, it is not necessary to be constituted with only an aromatic ring structure, and a part thereof may contain a chain structure or an alicyclic structure.

The "ring atom" of the ring structure as referred to means the number of atoms constituting a ring of an alicyclic structure, an aromatic ring structure, an aliphatic heterocyclic structure and the like, and in the case of polycyclic alicyclic structures, polycyclic aromatic ring structures and polycyclic aliphatic heterocyclic structures, the "ring atom" means the number of atoms constituting the polycycle.

Moreover, the "organic group" as referred to means a group that includes at least one carbon atom.

### [EFFECTS OF THE INVENTION]

According to the radiation-sensitive resin composition and the resist pattern-forming method of the aspects of the present invention, a resist pattern having less LWR and CDU, and being accompanied by fewer defects can be formed while a superior EL performance is exhibited. The polymer according to the still another aspect of the present invention can be suitably used as a polymer component of the aforementioned radiation-sensitive resin composition. The compound according to the yet another aspect of the present invention can be suitably used as a monomer of the aforementioned polymer. Therefore, these can be suitably used for manufacture of semiconductor devices in which further progress of miniaturization is expected in the future.

### [DESCRIPTION OF EMBODIMENTS]

### Radiation-Sensitive Resin Composition

The radiation-sensitive resin composition contains (A) a polymer and (B) an acid generator. Within a range not leading to impairment of the effects of the present invention, the radiation-sensitive resin composition may contain as a favorable component, a second polymer that differs from the first polymer (the polymer (A)) and has an acid-labile group-containing structural unit (hereinafter, may be also referred to as "(C) polymer" or "polymer (C)"), (D) an acid diffusion controller, and (E) a solvent, as well as other optional component.

Hereinafter, each component will be described.

### (A) Polymer

The polymer (A) has the structural unit (I). The polymer (A) constitutes a water repellent polymer additive in the radiation-sensitive resin composition. Since the radiation-sensitive resin composition contains the polymer (A) as a water repellent polymer additive, in forming the resist film, the polymer (A) that is a fluorine atom-containing polymer in the resist film tends to be unevenly distributed on the surface layer of the resist film due to oil repellent characteristics of the polymer (A). Consequently, the acid generating agent, the acid diffusion control agent and the like in liquid immersion lithography can be prevented from elution into a liquid immersion medium. In addition, due to water repellent characteristics of the polymer (A), an advancing contact angle of a liquid immersion medium on the resist film can be controlled to fall within a desired range, whereby generation of bubble defects can be inhibited. Furthermore, a greater receding contact angle of the liquid immersion medium on the resist film is attained, whereby an exposure by high-speed scanning without being accompanied by residual water beads is enabled. Thus, when the radiation-sensitive resin composition contains the polymer (A) as the water repellent polymer additive, a resist film suitable for liquid immersion lithography process can be formed.

In addition, since the polymer (A) as the water repellent polymer additive has the structural unit (I), the radiation-sensitive resin composition is superior in LWR performance, CDU performance, EL performance and inhibitory ability of defects (hereinafter, these may be taken together also referred to as "LWR performance, etc.,").

Although not necessarily clarified, the reason for exerting the effects described above resulting from the radiation-sensitive resin composition having the aforementioned constitution is presumed as in the following, for example. Specifically, since at least any one of Z¹, Z² and R³ adjacent to -COO- in the above formula (1) of the structural unit (I) in the polymer (A) contains a fluorine atom, R³ can exhibit alkali-lability, whereby a carboxy group is generated upon a development with an alkali. In addition, since at least any one of Z¹ to Z⁴, the ring structure (a) and the ring structure (b) in the vicinity of -COO- described above contains a hetero atom having a valency of no less than 2, hydrophilicity of the surface of the resist film formed from the radiation-sensitive resin composition containing the polymer (A) after the development with an alkali may be greater as compared with a case in which a conventional water repellent polymer additive is employed. As a result, performances of inhibiting defects derived from a development of the radiation-sensitive resin composition are improved, and additionally, the LWR performance, the CDU performance and the EL performance are also improved.

The polymer (A) preferably has a greater percentage content (% by mass) of fluorine atoms than that of the polymer (C) described later in the radiation-sensitive resin composition. When the percentage content of fluorine atoms of the polymer (A) is greater than the percentage content of fluorine atoms of the polymer (C), the extent of the uneven distribution described above increases, whereby characteristics such as water repellency and elution inhibitory ability of the resultant resist film are improved.

The percentage content of fluorine atoms of the polymer (A) is preferably no less than 1% by mass, more preferably 2% by mass to 60% by mass, still more preferably 4% by mass to 40% by mass, and particularly preferably 7% by mass to 30% by mass. When the percentage content of fluorine atoms of the polymer (A) is less than the lower limit, hydrophobicity of the surface of a resist film may be lowered. It is to be noted that the percentage content (% by mass) of fluorine atoms of the polymer may be obtained by determining the structure of the polymer with a ¹³C-NMR spectrometry, and calculating from the structure.

It is preferred that the polymer (A) has a second structural unit represented by the following formula (2) (hereinafter, may be also referred to as "structural unit (II)") described later, in addition to the structural unit (I). Further, the polymer (A) may have a third structural unit (hereinafter, may be also referred to as "structural unit (III)") described later, which contains a fluorine atom and is a structural unit other than the structural unit (I), and may also have other structural unit except for the structural units (I) to (III). The polymer (A) may have one, or two or more types of each of the structural units.

Hereinafter, each structural unit will be described.

### Structural Unit (I)

The structural unit (I) is represented by the following formula (1).

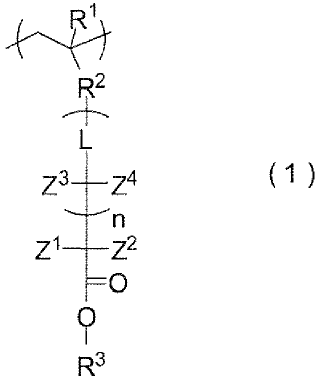

In the above formula (1), R¹ represents a hydrogen atom, a fluorine atom, a methyl group or a trifluoromethyl group; R² represents a divalent linking group; Z¹ to Z⁴ each independently represent a hydrogen atom, a fluorine atom, a monovalent hydrocarbon group, a monovalent fluorinated hydrocarbon group, or a monovalent group that contains a hetero atom having a valency of no less than 2; L represents a single bond or a divalent hydrocarbon group, wherein at least two of Z³, Z⁴ and L may taken together represent a ring structure (a) having 3 to 20 ring atoms together with the carbon atom to which the at least two of Z³, Z⁴ and L bond, and wherein at least two of Z¹ to Z⁴ and L may taken together represent a ring structure (b) having 3 to 8 ring atoms together with the carbon atom to which the at least two of Z¹ to Z⁴ bond; n is 0 or 1; and R³ represents a monovalent hydrocarbon group or a monovalent fluorinated hydrocarbon group, wherein at least any one of Z¹, Z² and R³ contains a fluorine atom, and wherein at least any one of Z¹ to Z⁴, the ring structure (a) and the ring structure (b) contains a hetero atom having a valency of no less than 2, and in a case in which R² represents -COO- and n is 0, both Z¹ and Z² do not represent an alkoxy group.

R¹ represents, in light of the degree of copolymerization of a monomer that gives a structural unit (I), preferably a hydrogen atom or a methyl group, and more preferably a methyl group.

The divalent linking group represented by R² is exemplified by a divalent group containing at least one hetero atom, and the like, and examples thereof include -O-, -CO-, -COO-, -CONR'-, -S-, -CS-, -COS-, -CSO-, and the like, wherein R' represents a monovalent hydrocarbon group having 1 to 10 carbon atoms.

The monovalent hydrocarbon group which may be represented by Z¹ to Z⁴ and R³ is exemplified by a monovalent chain hydrocarbon group having 1 to 20 carbon atoms, a monovalent alicyclic hydrocarbon group having 3 to 20 carbon atoms, a monovalent aromatic hydrocarbon group having 6 to 20 carbon atoms, and the like.

Examples of the monovalent chain hydrocarbon group include:
alkyl groups such as a methyl group, an ethyl group, a n-propyl group, an i-propyl group, a n-butyl group, an i-butyl group, a sec-butyl group and a t-butyl group;
alkenyl groups such as an ethenyl group, a propenyl group, a butenyl group and a pentenyl group;
alkynyl groups such as an ethynyl group, a propynyl group, a butynyl group and a pentynyl group; and the like.

Examples of the monovalent alicyclic hydrocarbon include:
monocyclic cycloalkyl groups such as a cyclopropyl group, a cyclobutyl group, a cyclopentyl group and a cyclohexyl group;
polycyclic cycloalkyl groups such as a norbornyl group, an adamantyl group and a tricyclodecyl group;
monocyclic cycloalkenyl groups such as a cyclopropenyl group, a cyclobutenyl group, a cyclopentenyl group and a cyclohexenyl group;
polycyclic cycloalkenyl groups such as a norbornenyl group and a tricyclodecenyl group; and the like.

Examples of the monovalent aromatic hydrocarbon group include:
aryl groups such as a phenyl group, a tolyl group, a xylyl group, a naphthyl group and an anthryl group;
aralkyl groups such as a benzyl group, a phenethyl group, a naphthylmethyl group and an anthrylmethyl group; and the like.

The monovalent fluorinated hydrocarbon group which may be represented by Z¹ to Z⁴ and R³ is exemplified by a monovalent fluorinated chain hydrocarbon group having 1 to 20 carbon atoms, a monovalent fluorinated alicyclic hydrocarbon group having 3 to 20 carbon atoms, a monovalent fluorinated aromatic hydrocarbon group having 6 to 20 carbon atoms, and the like.

Examples of the monovalent fluorinated chain hydrocarbon group include:
fluorinated alkyl groups such as a fluoromethyl group, a difluoromethyl group, a trifluoromethyl group, a fluoroethyl group, a trifluoroethyl group, a pentafluoroethyl group, a fluoropropyl group, a trifluoro-n-propyl group, a pentafluoro-n-propyl group, a heptafluoro-n-propyl group, a fluoro-i-propyl group, a trifluoro-i-propyl group, a hexafluoro-i-propyl group, a heptafluoro-i-propyl group, a fluoro-n-butyl group and a nonafluoro-n-butyl group;
fluorinated alkenyl groups such as a fluoroethenyl group, a trifluoroethenyl group, a fluoropropenyl group, a pentafluoropropenyl group, a fluorobutenyl group and a nonafluorobutenyl group;
fluorinated alkynyl groups such as a fluoroethynyl group, a fluoropropynyl group, a trifluoropropynyl group, a fluorobutynyl group and a pentafluorobutynyl group; and the like.

Examples of the monovalent fluorinated alicyclic hydrocarbon group include:
monocyclic fluorinated cycloalkyl groups such as a fluorocyclopropyl group, a pentafluorocyclopropyl group, a fluorocyclobutyl group, a heptafluorocyclobutyl group, a fluorocyclopentyl group, a nonafluorocyclopentyl group, a fluorocyclohexyl group and an undecafluorocyclohexyl group;
polycyclic fluorinated cycloalkyl groups such as a fluoronorbornyl group, a heptafluoronorbornyl group, a fluoroadamantyl group and a pentadecafluoroadamantyl group;
monocyclic fluorinated cycloalkenyl groups such as a fluorocyclopropenyl group, a trifluorocyclopropenyl group, a fluorocyclobutenyl group, a pentafluorocyclobutyl group, a fluorocyclopentenyl group, a heptafluorocyclopentenyl group, a fluorocyclohexenyl group and a pentafluorocyclohexenyl group;
polycyclic fluorinated cycloalkenyl groups such as a fluoronorbomenyl group and a pentafluoronorbornenyl group; and the like.

Examples of the monovalent fluorinated aromatic hydrocarbon group include:
fluorinated aryl groups such as a fluorophenyl group, a difluorophenyl group, a trifluorophenyl group, a pentafluorophenyl group, a fluorotolyl group, a trifluorotolyl group, a fluoroxylyl group, a trifluoroxylyl group, a fluoronaphthyl group, a heptafluoronaphthyl group, a fluoroanthryl group and a nonafluoroanthryl group;
fluorinated aralkyl groups such as a fluorobenzyl group, a difluorobenzyl group, a trifluorobenzyl group, a pentafluorobenzyl group, a heptafluorobenzyl group, a fluorophenethyl group, a tetrafluorophenethyl group and a nonafluorophenethyl group; and the like.

The hetero atom having a valency of no less than 2 which may be contained in the monovalent group that contains a hetero atom having a valency of no less than 2 which may be represented by Z¹ to Z⁴ is not particularly limited as long as it is a hetero atom having an atomic valency of at least two, and examples thereof include an oxygen atom, a nitrogen atom, a sulfur atom, a silicon atom, a phosphorus atom, a boron atom, and the like. Of these, in light of polarity of the polymer (A) to be more adequate, and of ease in synthesis, the hetero atom is preferably a nonmetal element atom, more preferably an oxygen atom, a nitrogen atom, a sulfur atom, a phosphorus atom or a silicon atom, still more preferably an oxygen atom or a sulfur atom, and particularly preferably an oxygen atom.

The monovalent group that contains a hetero atom having a valency of no less than 2 represented by Z¹ to Z⁴ is exemplified by: a monovalent group consisting of a hetero atom and a hydrogen atom; a group (α) which is a monovalent hydrocarbon group having a hetero atom-containing group between carbon atoms or at the end on the atomic bonding side; a group (β) obtained by substituting a part or all of hydrogen atoms included in the hydrocarbon group and group (α) with a substituent having a hetero atom; and the like.

Examples of the monovalent group consisting of a hetero atom and a hydrogen atom include a hydroxy group, a sulfanyl group (-SH), an amino group, and the like.

Examples of the hetero atom-containing group include: divalent groups consisting of hetero atoms such as -SO-, -SO₂- and -SO₂O-; divalent groups having a carbon atom and a hetero atom such as -CO-, -COS-, -CONH-, - OCOO-, -OCOS-, -OCONH-, -SCONH-, -SCSNH- and -SCSS-; and the like. Of these, -COO-, -CONH-, -SO₂- and -SO₂O- are preferred, and -COO- is more preferred.

Examples of the substituent having a hetero atom include a hydroxy group, a carboxy group, a sulfanyl group (-SH), a keto group (=O), a thioketo group (=S), a nitrilo group (trivalent nitrogen atom), a halogen atom, and the like. Examples of the halogen atom include a fluorine atom, a chlorine atom, a bromine atom, an iodine atom, and the like. Of these, a fluorine atom is preferred.

Of these, as the substituent having a hetero atom, a hydroxy group, a carboxy group, a keto group and a nitrilo group are preferred, and a hydroxy group is more preferred.

Z¹ and Z² represent preferably a hydrogen atom, a fluorine atom, a monovalent fluorinated hydrocarbon group, or a monovalent group that contains a hetero atom having a valency of no less than 2, more preferably a hydrogen atom, a fluorine atom, a trifluoromethyl group or a group containing a lactone structure, still more preferably a hydrogen atom, a fluorine atom, a trifluoromethyl group or a butyrolacton-yl group, and particularly preferably a fluorine atom.

Z³ and Z⁴ represent preferably a hydrogen atom, a monovalent hydrocarbon group, or a monovalent group that contains a hetero atom having a valency of no less than 2, more preferably a hydrogen atom, a monovalent chain hydrocarbon group, a monovalent group containing an oxygen atom, or a monovalent group containing a sulfur atom, still more preferably a hydrogen atom, an alkyl group, a hydroxy group or an alkoxycarbonyl group, and particularly preferably a hydrogen atom, a methyl group, a hydroxy group, a methoxycarbonyl group or a methoxymethyl group.

R³ represents preferably a monovalent chain hydrocarbon group or a monovalent fluorinated chain hydrocarbon group, more preferably an alkyl group or a fluorinated alkyl group, and still more preferably a methyl group, an ethyl group, a trifluoroethyl group, a pentafluoro-n-propyl group or a hexafluoro-i-propyl group.

The divalent hydrocarbon group which may be represented by L is exemplified by a divalent chain hydrocarbon group having 1 to 30 carbon atoms, a divalent alicyclic hydrocarbon group having 3 to 30 carbon atoms, a divalent aromatic hydrocarbon group having 6 to 30 carbon atoms, and the like.

Examples of the divalent chain hydrocarbon group include:
alkanediyl groups such as a methanediyl group, an ethanediyl group, a propanediyl group and a butanediyl group;
alkenediyl groups such as an ethenediyl group, a propenediyl group and a butenediyl group;
alkynediyl groups such as an ethynediyl group, a propynediyl group and a butynediyl group; and the like.

Examples of the divalent alicyclic hydrocarbon group include:
monocyclic cycloalkanediyl groups such as a cyclopropanediyl group, a cyclobutanediyl group, a cyclopentanediyl group and a cyclohexanediyl group;
monocyclic cycloalkenediyl groups such as a cyclopropenediyl group and a cyclobutenediyl group;
polycyclic cycloalkanediyl groups such as a norbornanediyl group, an adamantanediyl group, a tricyclodecanediyl group and a tetracyclododecanediyl group;
polycyclic cycloalkenediyl groups such as a norbornenediyl group and a tricyclodecenediyl group; and the like.

Examples of the divalent aromatic hydrocarbon group include:
arenediyl groups such as a benzenediyl group, a toluenediyl group, a xylene diyl group, a naphthalenediyl group, an anthracenediyl group and a phenanthrenediyl group;
arenediyl (cyclo)alkanediyl groups such as a benzenediylmethanediyl group and a naphthalenediylcyclohexanediyl group; and the like.

Of these, the divalent hydrocarbon group is preferably the divalent chain hydrocarbon group or the divalent alicyclic hydrocarbon group, and more preferably the alkanediyl group or the cycloalkanediyl group.

L represents preferably a single bond or a divalent chain hydrocarbon group, and more preferably a single bond or a 1,1-ethanediyl group.

Examples of the ring structure (a) having 3 to 20 ring atoms which may be taken together represented by at least two of Z³, Z⁴ and L together with the carbon atom to which the at least two of Z³, Z⁴ and L bond include:
monocyclic alicyclic structures such as a cyclopropane structure, a cyclobutane structure, a cyclopentane structure and a cyclohexane structure;
polycyclic alicyclic structures such as a norbornane structure, an adamantane structure, a tricyclodecane structure and a tetracyclododecane structure;
monocyclic aliphatic heterocyclic structures such as an oxacyclopentane structure, an oxacyclohexane structure, a butyrolactone structure, a valerolactone structure, a thiacyclopentane structure, a thiacyclohexane structure, an azacyclopentane structure and an azacyclohexane structure;
polycyclic aliphatic heterocyclic structures such as an oxanorbornane structure, an oxaadamantane structure, a norbomanelactone structure, a thianorbornane structure and an azanorbomane structure; and the like.
Of these, the ring structure (a) is preferably the polycyclic alicyclic structure or the monocyclic aliphatic heterocyclic structure, and more preferably the adamantane structure, the oxacyclopentane structure or the thiacyclopentane structure.

Examples of the ring structure (b) having 3 to 8 ring atoms which may be taken together represented by at least two of Z¹ to Z⁴ and L together with the carbon atom to which the at least two of Z¹ to Z⁴ bond include:
monocyclic alicyclic structures such as a cyclopropane structure, a cyclobutane structure, a cyclopentane structure and a cyclohexane structure;
alicyclic structures such as a norbomane structure;
monocyclic aliphatic heterocyclic structures such as an oxacyclopentane structure, an oxacyclohexane structure, a butyrolactone structure and a valerolactone structure;
polycyclic aliphatic heterocyclic structures such as an oxanorbornane structure; and the like.

Of these, the ring structure (b) is preferably the monocyclic alicyclic structure or the monocyclic aliphatic heterocyclic structure, and more preferably the cyclopentane structure, the cyclohexane structure, the butyrolactone structure or the valerolactone structure.

It is to be noted that the ring structure (a) has 3 to 20 ring atoms, whereas the ring structure (b) has 3 to 8 ring atoms, because in a case in which the number of the ring atoms is greater than the upper limit, the ring structure may be so bulky that dissociation of the alkali-labile group is inhibited, and as a result, the effects of the invention may not be achieved.

In addition, when R² represents -COO- and n is 0, both Z¹ and Z² should not represent an alkoxy group since the structure of -COO-C (OR)-COO-(wherein, OR represents an alkoxy group) becomes unstable in this instance, leading to a failure in achieving the effects of the invention.

Examples of the structural unit (I) include structural units represented by the following formulae (1-1) to (1-3) (hereinafter, may be also referred to as "structural units (1-1) to (1-3)"), and the like.

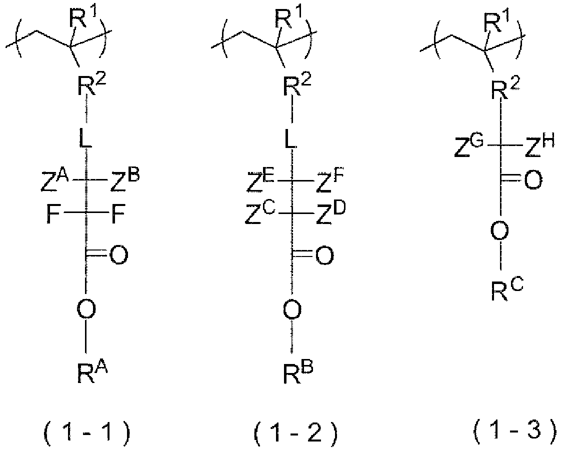

In the above formulae (1-1) to (1-3), R¹, R² and L are as defined in the above formula (1).

In the above formula (1-1), Z^{A} and Z^{B} each independently represent a hydrogen atom, a monovalent hydrocarbon group, or a monovalent group that contains a hetero atom having a valency of no less than 2, wherein at least two of Z^{A}, Z^{B} and L may taken together represent a ring structure (a') having 3 to 20 ring atoms together with the carbon atom to which the at least two of Z^{A}, Z^{B} and L bond, and wherein at least any one of Z^{A}, Z^{B} and the ring structure (a') contains a hetero atom having a valency of no less than 2; and R^{A} represents a monovalent hydrocarbon group or a monovalent fluorinated hydrocarbon group.

In the above formula (1-2), Z^{C}, Z^{D}, Z^{E} and Z^{F} each independently represent a hydrogen atom, a monovalent hydrocarbon group, or a monovalent group that contains a hetero atom having a valency of no less than 2, wherein at least two of Z^{E}, Z^{F} and L may taken together represent a ring structure (a") having 3 to 20 ring atoms together with the carbon atom to which the at least two of Z^{E}, Z^{F} and L bond, and wherein at least any one of Z^{C}, Z^{D}, Z^{E}, Z^{F} and the ring structure (a") contains a hetero atom having a valency of no less than 2; and R^{B} represents a monovalent fluorinated hydrocarbon group.

In the above formula (1-3), Z^{G} represents a fluorine atom or a monovalent fluorinated hydrocarbon group; Z^{H} represents a monovalent group that contains a hetero atom having a valency of no less than 2; and R^{C} represents a monovalent hydrocarbon group or a monovalent fluorinated hydrocarbon group.

The monovalent hydrocarbon group and the monovalent group that contains a hetero atom having a valency of no less than 2 which may be represented by Z^{A} to Z^{F}, and the monovalent group that contains a hetero atom having a valency of no less than 2 represented by Z^{H} are exemplified by respective groups similar to those exemplified as Z¹ to Z⁴.

Examples of the monovalent hydrocarbon group and the monovalent fluorinated hydrocarbon group which may be represented by R^{A} and R^{C}, the monovalent fluorinated hydrocarbon group represented by R^{B}, and the monovalent fluorinated hydrocarbon group which may be represented by Z^{G} include groups similar to the groups each exemplified as R³ described above, and the like.

Examples of the ring structure (a') and the ring structure (a") include ring structures similar to those exemplified as the ring structure (a) described above, and the like.

Of these, the structural unit (I) is preferably the structural unit (1-1) or the structural unit (1-2).

Examples of the structural unit (1-1) include structural units represented by the following formulae (1-1-1) to (1-1-10), and the like. Examples of the structural unit (1-2) include structural units represented by the following formulae (1-2-1) to (1-2-3), and examples of the structural unit (1-3) include structural unit represented by the following formulae (1-3-1) to (1-3-3), and the like (hereinafter, each may be also referred to as "structural units (1-1-1) to (1-3-3)").

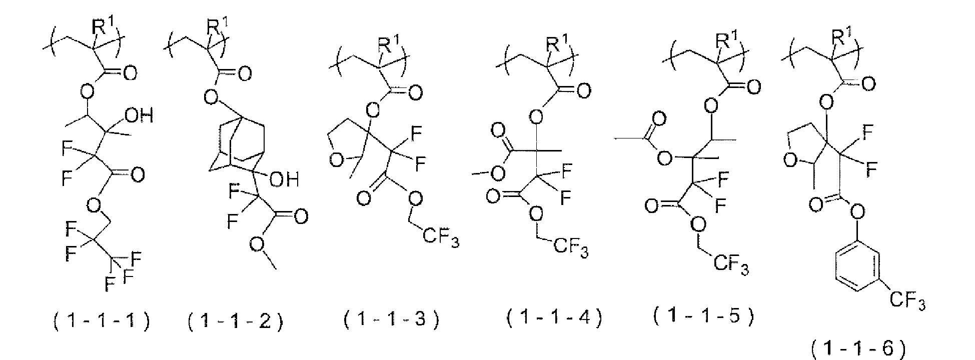

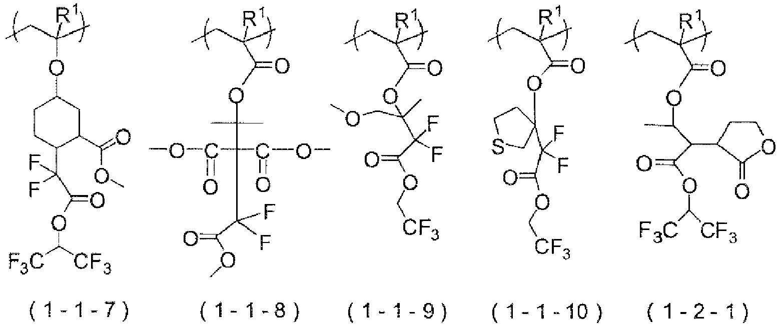

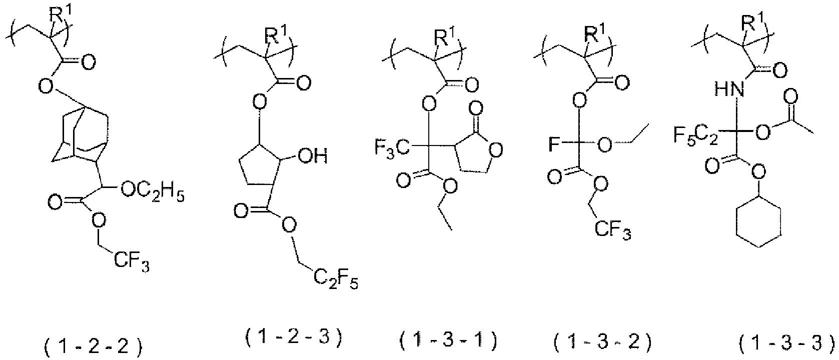

In the above formulae (1-1-1) to (1-3-3), R¹ is as defined in the above formula (1).

Of these, the structural unit (I) is preferably the structural unit (I-1-1), the structural unit (1-1-2), the structural unit (1-1-3), the structural unit (1-1-4), the structural unit (1-1-9), the structural unit (1-1-10), the structural unit (1-2-1) or the structural unit (1-3-1).

The lower limit of the proportion of the structural unit (I) contained with respect to the total structural units constituting the polymer (A) is preferably 10 mol%, more preferably 40 mol%, still more preferably 50 mol%, and particularly preferably 55 mol%. The upper limit of the proportion of the structural unit (I) is preferably 95 mol%, more preferably 90 mol%, and still more preferably 85 mol%. When the proportion falls within the above range, the LWR performance, etc., of the radiation-sensitive resin composition can be improved. When the proportion is less than the lower limit, the aforementioned effects may not be sufficiently exhibited. When the proportion is greater than the upper limit, the shape of the resist pattern formed from the radiation-sensitive resin composition may not be so favorable.

The compound that gives the structural unit (I) is exemplified by a compound represented by the following formula (i), and the like.

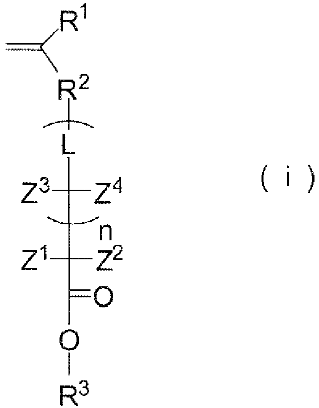

In the above formula (i), R¹ represents a hydrogen atom, a fluorine atom, a methyl group or a trifluoromethyl group; R² represents a divalent linking group; Z¹ to Z⁴ each independently represent a hydrogen atom, a fluorine atom, a monovalent hydrocarbon group, a monovalent fluorinated hydrocarbon group, or a monovalent group that contains a hetero atom having a valency of no less than 2; L represents a single bond or a divalent hydrocarbon group, wherein at least two of Z³, Z⁴ and L may taken together represent a ring structure (a) having 3 to 20 ring atoms together with the carbon atom to which the at least two of Z³, Z⁴ and L bond, and wherein at least two of Z¹ to Z⁴ and L may taken together represent a ring structure (b) having 3 to 8 ring atoms together with the carbon atom to which the at least two of Z¹ to Z⁴ bond; n is 0 or 1; and R³ represents a monovalent hydrocarbon group or a monovalent fluorinated hydrocarbon group, wherein at least any one of Z¹, Z² and R³ contains a fluorine atom, and wherein at least any one of Z¹ to Z⁴, the ring structure (a) and the ring structure (b) contains a hetero atom having a valency of no less than 2, and in a case in which R² represents -COO- and n is 0, both Z¹ and Z² do not represent an alkoxy group.

Examples of the compound (i) include compounds represented by the following formulae (1 m-1) to (1 m-3) (hereinafter, may be also referred to as "compounds (1 m-1) to (1 m-3)"), and the like.

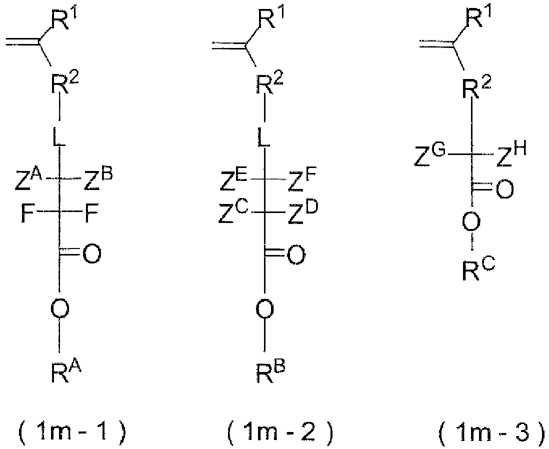

In the above formula (1 m-1) to (1 m-3), R¹, R² and L are as defined in the above formula (1).

In the above formula (1 m-1), Z^{A} and Z^{B} each independently represent a hydrogen atom, a monovalent hydrocarbon group, or a monovalent group that contains a hetero atom having a valency of no less than 2, wherein at least two of Z^{A}, Z^{B} and L may taken together represent a ring structure (a') having 3 to 20 ring atoms together with the carbon atom to which the at least two of Z^{A}, Z^{B} and L bond, and wherein at least any one of Z^{A}, Z^{B} and the ring structure (a') contains a hetero atom having a valency of no less than 2; R^{A} represents a monovalent hydrocarbon group or a monovalent fluorinated hydrocarbon group.

In the above formula (1 m-2), Z^{C}, Z^{D}, Z^{E} and Z^{F} each independently represent a hydrogen atom, a monovalent hydrocarbon group, or a monovalent group that contains a hetero atom having a valency of no less than 2, wherein at least two of Z^{E}, Z^{F} and L may taken together represent a ring structure (a") having 3 to 20 ring atoms together with the carbon atom to which the at least two of Z^{E}, Z^{F} and L bond, and wherein at least any one of Z^{C}, Z^{D}, Z^{E}, Z^{F} and the ring structure (a") contains a hetero atom having a valency of no less than 2; and R^{B} represents a monovalent fluorinated hydrocarbon group.

In the above formula (1 m-3), Z^{G} represents a fluorine atom or a monovalent fluorinated hydrocarbon group; Z^{H} represents a monovalent group that contains a hetero atom having a valency of no less than 2; and R^{C} represents a monovalent hydrocarbon group or a monovalent fluorinated hydrocarbon group.

Examples of the compound (1 m-1) include compounds represented by the following formulae (1 m-1-1) to (1 m-1-10). Examples of the compound (1 m-2) include compounds represented by the following formulae (1 m-2-1) to (1 m-2-3), and examples of the compound (1 m-3) include compounds represented by the following formulae (1 m-3-1) to (1 m-3-3), and the like.

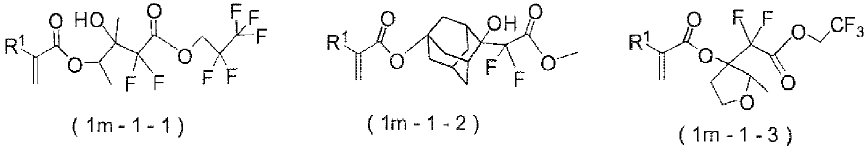

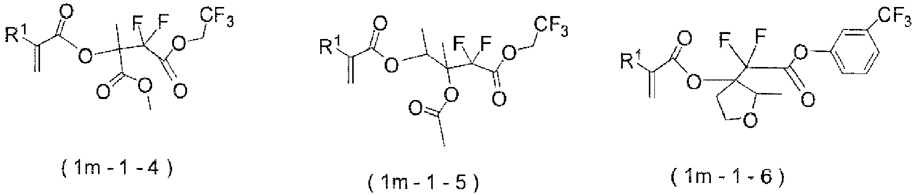

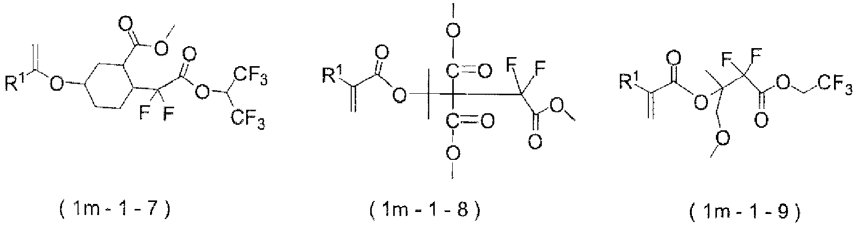

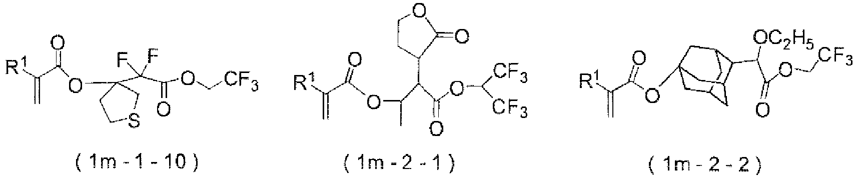

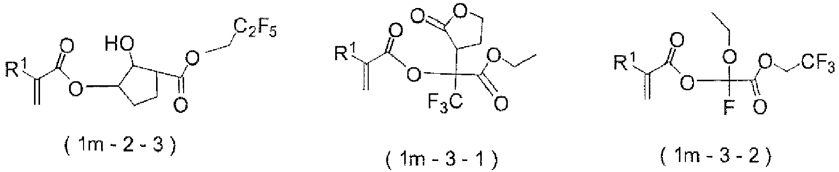

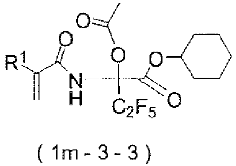

In the above formulae (1 m-1-1) to (1 m-3-3), R¹ represents a hydrogen atom, a fluorine atom, a methyl group or a trifluoromethyl group.

Of these, the compound (1 m-1-1), the compound (1 m-1-2), the compound (1 m-1-3), the compound (1 m-1-4), the compound (1 m-1-9), the compound (1 m-1-10), the compound (1 m-2-1) and the compound (1 m-3-1) are preferred.

### Synthesis Method of Compound (i)

For example, in the case of the compound (i'-1a) which is the compound (1 m-1), wherein R² represents -COO-, and Z^{A} represents a hydroxy group, the compound (i) may be conveniently synthesized in high yield by a synthesis method according to the following scheme, including:
(A) a step of reacting a hydroxy group-containing ketone compound represented by the following formula (1-a1) with a (meth)acryloyl compound represented by the following formula (1-b1) to obtain a (meth)acryloyloxy group-containing ketone compound represented by the following formula (1-c1); and
(B) a step of reacting the (meth)acryloyloxy group-containing ketone compound with a halo-α,α-difluoroacetic acid ester compound represented by the following formula (1-d1) in the presence of zinc.

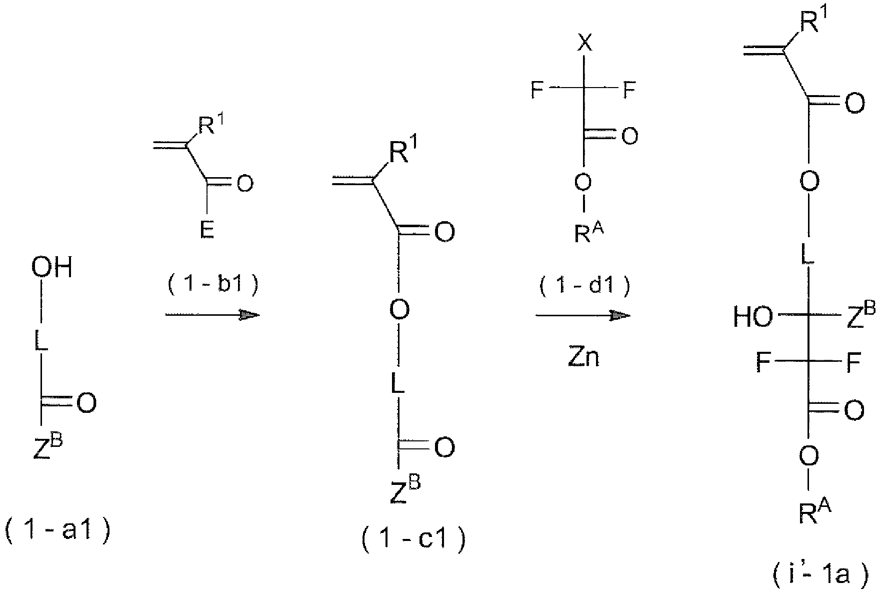

In the above scheme, R¹ represents a hydrogen atom, a fluorine atom, a methyl group or a trifluoromethyl group; L represents a single bond or a divalent hydrocarbon group, wherein at least two of Z^{B} represent a hydrogen atom, a monovalent hydrocarbon group, or a monovalent group that contains a hetero atom having a valency of no less than 2; Z^{B} and L may taken together represent a ring structure (a') having 3 to 20 ring atoms together with the carbon atom to which Z^{B} and L bond; R^{A} represents a monovalent hydrocarbon group or a monovalent fluorinated hydrocarbon group; E represents a halogen atom, a hydroxy group or -OCOR'; R' represents a monovalent hydrocarbon group; and X represents a halogen atom.

The halogen atom which may be represented by E is, in light of an improvement of the yield, preferably a chlorine atom or a bromine atom, and more preferably a chlorine atom.

The halogen atom represented by X is, in light of an improvement of the yield, preferably a chlorine atom or a bromine atom, and more preferably a bromine atom.

The (meth)acryloyloxy group-containing ketone compound (1-c1) may be obtained by reacting the hydroxy group-containing ketone compound (1-a1) with the (meth)acryloyl compound (1-b1) in the presence of a base such as triethylamine in a solvent such as dichloromethane. The compound (i'-1a) may be obtained by reacting the resulting compound (1-c1) with the halo-α,α-difluoroacetic acid ester compound (1-d1) in the presence of zinc and trimethylsilyl chloride or the like as an activator in a solvent such as tetrahydrofuran.

Furthermore, for example, in the case of the compound (i'-1b) which is the compound (1 m-1), wherein R² represents -COO-, and L represents a single bond, the compound (i) may be conveniently synthesized in high yield by a synthesis method according to the following scheme, including:
(A') a step of reacting a ketone compound represented by the following formula (1-a2) with a halo-α,α-difluoroacetic acid ester compound represented by the following formula (1-b2) in the presence of zinc to obtain a hydroxy compound represented by the following formula (1-c2); and
(B') a step of reacting the hydroxy compound with a (meth)acryloyl compound represented by the following formula (1-d2).

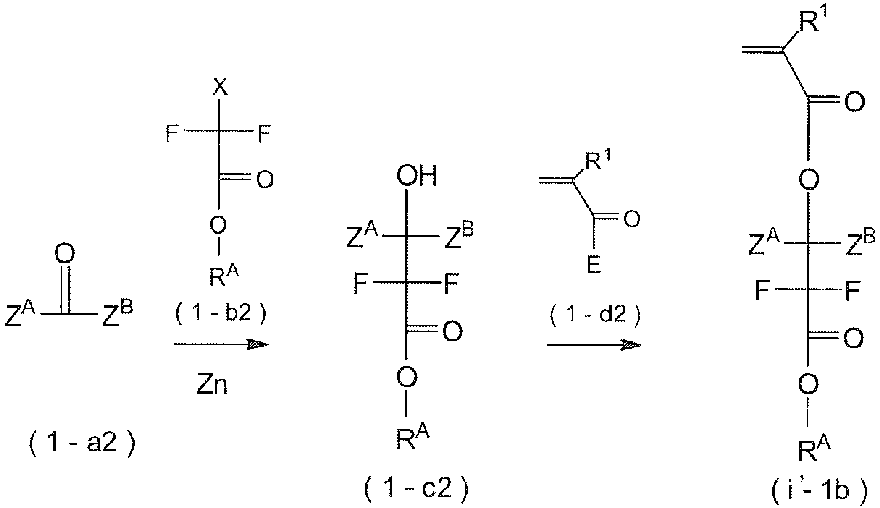

In the above scheme, R¹ represents a hydrogen atom, a fluorine atom, a methyl group or a trifluoromethyl group; Z^{A} and Z^{B} each independently represent a hydrogen atom, a monovalent hydrocarbon group, or a monovalent group that contains a hetero atom having a valency of no less than 2; Z^{A} and Z^{B} may taken together represent a ring structure (a') having 3 to 20 ring atoms together with the carbon atom to which Z^{B} and L bond, wherein at least any one of Z^{A}, Z^{B} and the ring structure (a') containing a hetero atom having a valency of no less than 2; R^{A} represents a monovalent hydrocarbon group or a monovalent fluorinated hydrocarbon group; E represents a halogen atom, a hydroxy group or -OCOR'; R' represents a monovalent hydrocarbon group; and X represents a halogen atom.

The hydroxy compound (1-c2) may be obtained by reacting the ketone compound (1-a2) with the halo-α,α-difluoroacetic acid ester compound (1-b2) in the presence of zinc and trimethylsilyl chloride or the like as an activator in a solvent such as tetrahydrofuran. The compound (i'-1b) may be obtained by reacting the resulting compound (1-c2) with the (meth)acryloyl compound (1-d2) in the presence of a base such as triethylamine in a solvent such as acetonitrile.

Moreover, for example, in the case of the compound (1 m-2) wherein R² represents -COO-, and Z^{D} and Z^{F} each represent a hydrogen atom, the compound (i) may be conveniently synthesized in high yield by a synthesis method according to the following scheme, including:
(A") a step of reacting an acylacetic acid ester compound represented by the following formula (1-a3) with an organic halide represented by the following formula (1-b3) to obtain a substituted acylacetic acid ester compound represented by the following formula (1-c3);
(B") a step of hydrogenating the substituted acylacetic acid ester compound to obtain a hydroxy compound represented by the following formula (1-d3); and
(C") a step of reacting the hydroxy compound with a (meth)acryloyl compound represented by the following formula (1-e3).

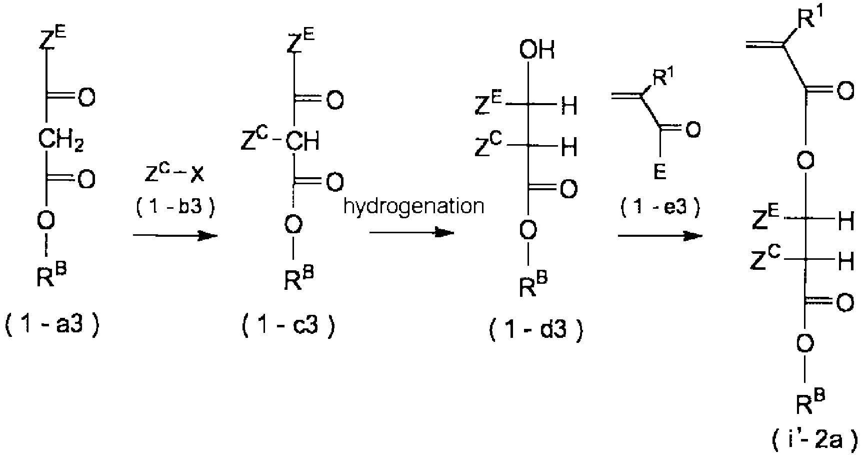

In the above scheme, Z^{C} and Z^{E} each independently represent a monovalent hydrocarbon group, or a monovalent group that contains a hetero atom having a valency of no less than 2; at least any one of Z^{C} and Z^{E} contains a hetero atom having a valency of no less than 2; R^{B} represents a monovalent fluorinated hydrocarbon group; E represents a halogen atom, a hydroxy group or -OCOR'; R' represents a monovalent hydrocarbon group; and X represents a halogen atom.

By allowing the acylacetic acid ester compound (1-a3) to react with the organic halide (1-b3) in the presence of a base such as sodium hydride in a solvent such as tetrahydrofuran, the substituted acylacetic acid ester compound (1-c3) is obtained. By subjecting the resulting substituted acylacetic acid ester compound (1-c3) to hydrogenation by using a hydrogenating agent such as sodium borohydride in a solvent such as tetrahydrofuran, the hydroxy compound (1-d3) is obtained. By allowing the resulting hydroxy compound (1-d3) to react with the (meth)acryloyl compound (1-e3) in the presence of a base such as triethylamine in a solvent such as acetonitrile, the compound (i'-2a) is obtained.

It is to be noted that conversion of the monovalent hydrocarbon group into a monovalent fluorinated hydrocarbon group which may be represented by R^{A} and R^{B}, may be executed by, for example, carrying out a treatment in the presence of a strong acid such as trifluoroacetic acid in a solvent such as dichloromethane, thereafter allowing the reaction product to react with a chlorinating agent such as oxalyl chloride in a solvent such as toluene, and further allowing to react with a fluorine atom-containing alcohol such as 1,1,1,3,3,3-hexafluoro-2-propanol and 2,2,2-trifluoroethanol in the presence of a base such as triethylamine.

The compound (i) may be isolated through appropriately purifying the resulting reaction product by a liquid separation operation, distillation, recrystallization, column chromatography and/or the like.

The compound (i) having a structure other than those described above can be also synthesized by a method similar to the aforementioned method.

### Structural Unit (II)

The structural unit (II) is represented by the following formula (2). The group represented by -CR⁵R⁶R⁷ in the structural unit (II) is an acid-labile group. The "acid-labile group" as referred to means a group that substitutes for a hydrogen atom of a carboxy group, etc., and is dissociated by an action of an acid. When the polymer (A) has the structural unit (II), the solubility in a developer solution at a light-exposed site is improved, and as a result, the LWR performance, etc., of the radiation-sensitive resin composition can be improved.

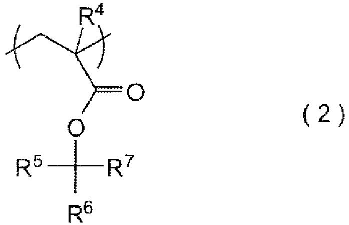

In the above formula (2), R⁵ represents a hydrogen atom, a fluorine atom, a methyl group or a trifluoromethyl group; R⁶ represents a monovalent chain hydrocarbon group having 1 to 10 carbon atoms or a monovalent alicyclic hydrocarbon group having 3 to 20 carbon atoms; R⁷ and R⁸ each independently represent a monovalent chain hydrocarbon group having 1 to 10 carbon atoms or monovalent alicyclic hydrocarbon group having 3 to 20 carbon atoms, or these groups taken together represent an alicyclic structure having 3 to 20 carbon atoms together with the carbon atom to which these groups bond.

In light of the degree of copolymerization of a monomer that gives a structural unit (II), R⁴ represents preferably a hydrogen atom or a methyl group, and more preferably a methyl group.

Examples of the monovalent chain hydrocarbon group having 1 to 10 carbon atoms which may be represented by R⁵, R⁶ and R⁷ include:
alkyl groups such as a methyl group, an ethyl group, a n-propyl group and an i-propyl group;
alkenyl groups such as an ethenyl group, a propenyl group and a butenyl group;
alkynyl groups such as an ethynyl group, a propynyl group and a butynyl group; and the like.

Examples of the represented by the monovalent alicyclic hydrocarbon group having 3 to 20 carbon atoms R⁵, R⁶ and R⁷ include:
monocyclic cycloalkyl groups such as a cyclopentyl group and a cyclohexyl group;
monocyclic cycloalkenyl groups such as a cyclopentenyl group and a cyclohexenyl group;
polycyclic cycloalkyl groups such as a norbornyl group, an adamantyl group and a tricyclodecyl group;
polycyclic cycloalkenyl groups such as a norbornenyl group and a tricyclodecenyl group; and the like.

Examples of the alicyclic structure having 3 to 20 carbon atoms taken together represented by these groups together with the carbon atom to which these groups bond include:
monocyclic cycloalkane structures such as a cyclopropane structure, a cyclobutane structure, a cyclopentane structure, a cyclohexane structure, a cycloheptane structure and a cyclooctane structure;
polycyclic cycloalkane structures such as a norbomane structure, an adamantane structure, a tricyclodecane structure and a tetracyclododecane structure; and the like.

The structural unit (II) is represented by any of the following formulae (2-1) to (2-4) (hereinafter, may be also referred to as "structural units (II-1) to (II-4)").

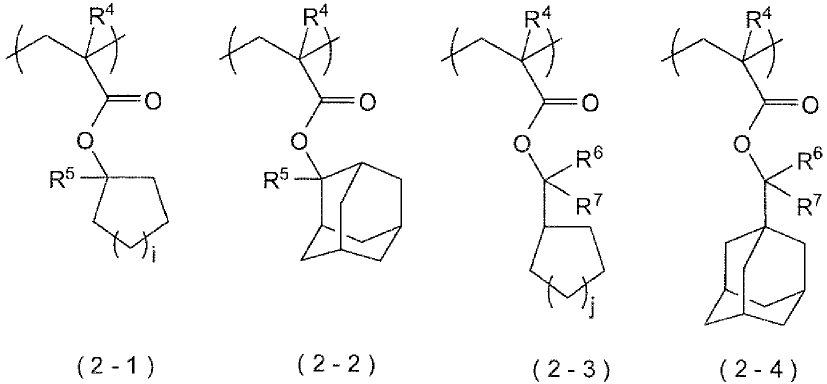

In the above formulae (2-1) to (2-4), R⁵ to R⁷ are as defined in the above formula (2), and i and j are each independently an integer of 1 to 4.

In the above formulae (2-1) to (2-4), i and j are preferably 1, 2 or 4, more preferably 1 or 4, and still more preferably 1.

Examples of the structural units (II-1) to (II-4) include structural units represented by the following formulae, and the like.

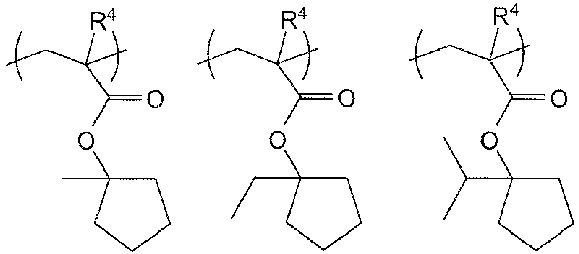

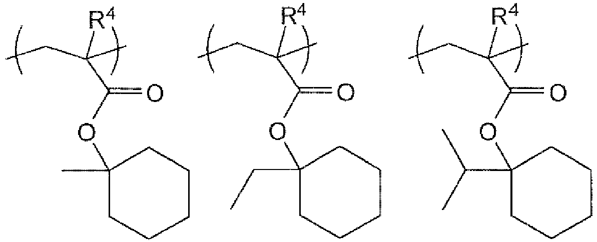

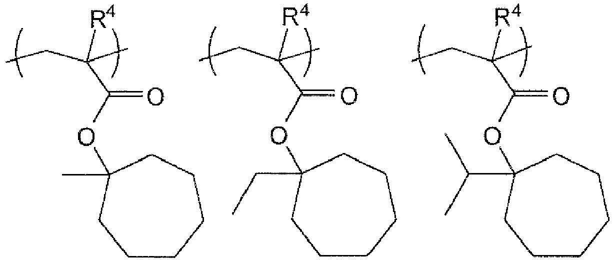

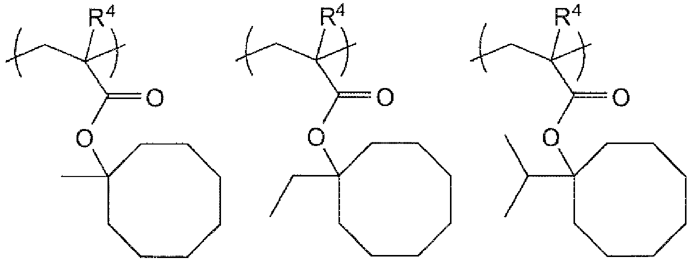

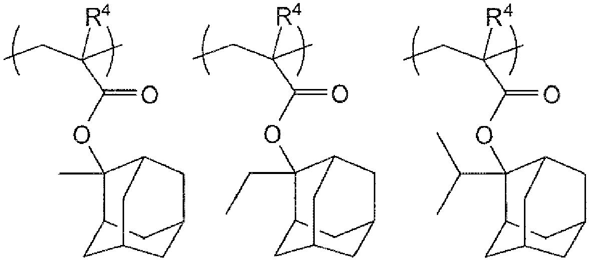

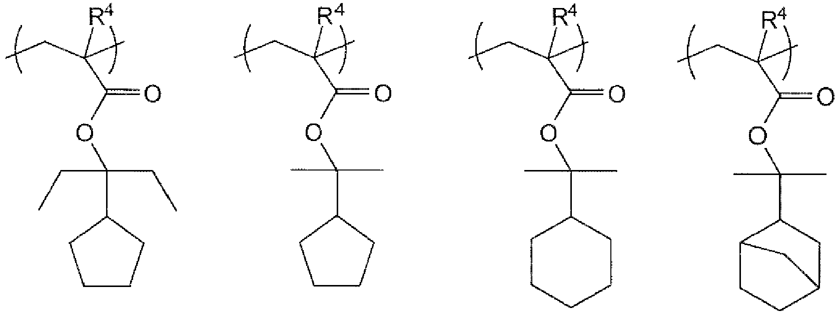

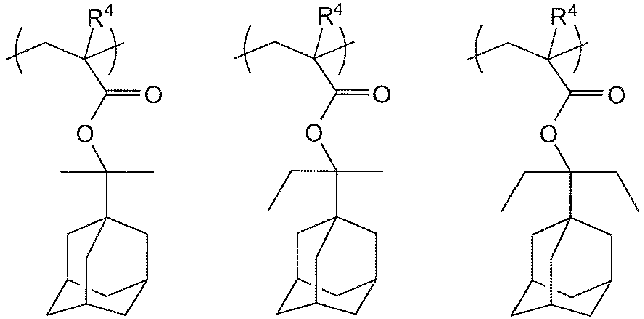

In the above formulae, R⁴ is as defined in the above formula (2).

The structural unit (II) contains preferably an alicyclic structure, more preferably a cycloalkane structure, and still more preferably a cyclopentane structure, a cyclohexane structure, a cyclooctane structure or an adamantane structure. Furthermore, the structural unit (II) is derived from preferably 1-alkyl-1-cyclopentyl (meth)acrylate, 1-alkyl-1-cyclooctyl (meth)acrylate, 2-alkyl-2-adamantyl (meth)acrylate, 2-(adamantan-1-yl)propan-2-yl (meth)acrylate or 2-cyclohexyl propane-2-yl (meth)acrylate, and more preferably 1-methyl-1-cyclopentyl (meth)acrylate, 1-i-propyl-1-cyclopentyl (meth)acrylate, 1-ethyl-1-cyclooctyl (meth)acrylate, 2-methyl-2-adamantyl (meth)acrylate, 2-i-propyl-2-adamantyl (meth)acrylate, 2-(adamantan-1-yl)propan-2-yl (meth)acrylate or 2-cyclohexyl propan-2-yl (meth)acrylate.

The lower limit of the proportion of the structural unit (II) contained with respect to the total structural units constituting the polymer (A) is preferably 5 mol%, more preferably 10 mol%, still more preferably 15 mol%, and particularly preferably 18 mol%. The upper limit of the proportion of the structural unit (II) is preferably 80 mol%, more preferably 60 mol%, still more preferably 40 mol%, and particularly preferably 35 mol%. When the proportion of the structural unit (II) falls within the above range, the solubility in a developer solution of the polymer (A) can be more improved, and as a result, the LWR performance, etc., of the radiation-sensitive resin composition can be further improved.

### Structural Unit (III)

The structural unit (III) is other than the structural unit (I), and contains a fluorine atom. When the polymer (A) further has the structural unit (III), the percentage content of fluorine atoms can be adjusted, and as a result, the LWR performance, etc., of the radiation-sensitive resin composition can be further improved. The structural unit (III) is exemplified by a structural unit represented by the following formula (f-a) (hereinafter, may be also referred to as "structural unit (III-1)"), a structural unit represented by the following formula (f-b) (hereinafter, may be also referred to as "structural unit (III-2)"), and the like.

### Structural Unit (III-1)

The structural unit (III-1) is represented by the following formula (f-a).

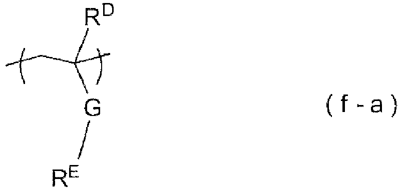

In the above formula (f-a), R^{D} represents a hydrogen atom, a methyl group or a trifluoromethyl group; G represents a single bond, an oxygen atom, a sulfur atom, -CO-O-, -SO₂-O-NH-, -CO-NH- or -O-CO-NH-; R^{E} represents a monovalent chain hydrocarbon group having 1 to 6 carbon atoms and at least one fluorine atom, or a monovalent aliphatic cyclic hydrocarbon group having 4 to 20 carbon atoms and at least one fluorine atom.

Examples of the chain hydrocarbon group having 1 to 6 carbon atoms and having at least one fluorine atom which may be represented by R^{E} include a trifluoromethyl group, a 2,2,2-trifluoroethyl group, a perfluoroethyl group, a 2,2,3,3,3-pentafluoropropyl group, a 1,1,1,3,3,3-hexafluoropropyl group, a perfluoro n-propyl group, a perfluoro i-propyl group, a perfluoro n-butyl group, a perfluoro i-butyl group, a perfluoro t-butyl group, a 2,2,3,3,4,4,5,5-octafluoropentyl group, a perfluorohexyl group, and the like.

Examples of the aliphatic cyclic hydrocarbon group having 4 to 20 carbon atoms and at least one fluorine atom which may be represented by R^{E} include a monofluorocyclopentyl group, a difluorocyclopentyl group, a perfluorocyclopentyl group, a monofluorocyclohexyl group, a difluorocyclopentyl group, a perfluorocyclohexylmethyl group, a fluoronorbornyl group, a fluoroadamantyl group, a fluorobornyl group, a fluoroisobornyl group, a fluorotricyclodecyl group, a fluorotetracyclodecyl group, and the like.

Examples of the monomer that gives a structural unit (3a) include a (meth)acrylic acid trifluoromethyl ester, a (meth)acrylic acid 2,2,2-trifluoroethyl ester, a methyl (meth)acrylic acid 2,2,2-trifluoroethyloxycarbonyl ester, a (meth)acrylic acid perfluoroethyl ester, a (meth)acrylic acid perfluoro n-propyl ester, a (meth)acrylic acid perfluoro i-propyl ester, a (meth)acrylic acid perfluoro n-butyl ester, a (meth)acrylic acid perfluoro i-butyl ester, a (meth)acrylic acid perfluoro t-butyl ester, a (meth)acrylic acid 2-(1,1,1,3,3,3-hexafluoropropyl) ester, a (meth)acrylic acid 1-(2,2,3,3,4,4,5,5-octafluoropentyl) ester, a (meth)acrylic perfluorocyclohexylmethyl acid ester, a (meth)acrylic acid 1-(2,2,3,3,3-pentafluoropropyl) ester, a (meth)acrylic acid monofluorocyclopentyl ester, a (meth)acrylic acid difluorocyclopentyl ester, a (meth)acrylic acid perfluorocyclopentyl ester, a (meth)acrylic acid monofluorocyclohexyl ester, a (meth)acrylic acid difluorocyclopentyl ester, a (meth)acrylic acid perfluorocyclohexylmethyl ester, a (meth)acrylic acid fluoronorbornyl ester, a (meth)acrylic acid fluoroadamantyl ester, a (meth)acrylic acid fluorobornyl ester, a (meth)acrylic acid fluoroisobornyl ester, a (meth)acrylic acid fluorotricyclodecyl ester, a (meth)acrylic acid fluorotetracyclodecyl ester, and the like.

Of these, a (meth)acrylic acid 2,2,2-trifluoroethyloxycarbonylmethyl ester is preferred.

The proportion of the structural unit (III-1) contained with respect to the total structural units constituting the polymer (A) is preferably 0 mol% to 30 mol%, more preferably 5 mol% to 30 mol%, and still more preferably 5 mol% to 20 mol%. When the proportion is thus adjusted, the LWR performance, etc., of the radiation-sensitive resin composition can be further improved.

### Structural Unit (III-2)

The structural unit (III-2) is represented by the following formula (f-b).

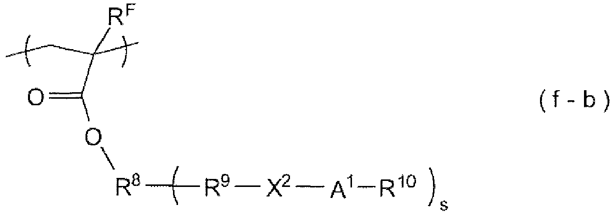

In the above formula (f-b), R^{F} represents a hydrogen atom, a methyl group or a trifluoromethyl group; R⁸ represents a hydrocarbon group having 1 to 20 carbon atoms and having a valency of (s+1), which also includes the group having a structure in which an oxygen atom, a sulfur atom, -NR'-, a carbonyl group, -CO-O- or -CO-NH-R⁸ is bonded to the end on the side adjacent to R⁹; R' represents a hydrogen atom or a monovalent organic group; R⁹ represents a single bond, a divalent chain hydrocarbon group having 1 to 10 carbon atoms or a divalent aliphatic cyclic hydrocarbon group having 4 to 20 carbon atoms; X² represents a divalent chain hydrocarbon group having 1 to 20 carbon atoms that contains at least one fluorine atom; A¹ represents an oxygen atom, -NR"-, -COO-* or -SO₂-O-*; R" represents a hydrogen atom or a monovalent organic group, wherein * denotes a binding site to R¹⁰; R¹⁰ represents a hydrogen atom or a monovalent organic group; s is an integer of 1 to 3, wherein in a case in which s is 2 or 3, a plurality of R⁹s, a plurality of X²s, a plurality of a plurality of A¹s and a plurality of R¹⁰s may be each identical or different with each other.

R¹⁰ preferably represents a hydrogen atom, since the solubility of the polymer (A) in an alkaline developer solution can be improved.

The monovalent organic group represented by R¹⁰ is exemplified by a hydrocarbon group having 1 to 30 carbon atoms which may have an acid-labile group, an alkali-labile group or a substituent, and the like.

Examples of the structural unit (III-2) include the structural units represented by the following formulae (f-b-1) to (f-b-3) (hereinafter, may be also referred to as "structural unit (III-2-1) to (III-2-3)"), and the like.

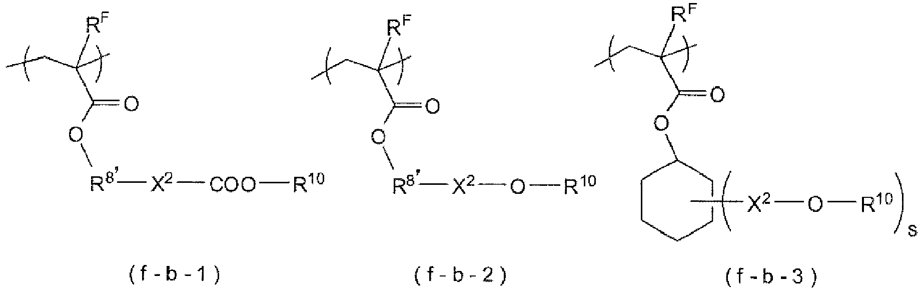

In the above formulae (f-b-1) to (f-b-3), R^{8'} represents a divalent linear, branched or cyclic saturated or unsaturated hydrocarbon group having 1 to 20 carbon atoms; R^{F}, X² , R¹⁰ and s are as defined in the above formula (f-b), wherein in a case in which s is 2 or 3, a plurality of X²s and a plurality of R¹⁰s may be each identical or different with each other.

The structural unit (III-2) is preferably the structural unit (III-2-2), more preferably those wherein: R^{8'} represents a branched hydrocarbon group; X² represents a perfluoroalkanediyl group; and R¹⁰ represents a hydrogen atom, and still more preferably a structural unit derived from 2-hydroxy-2-trifluoromethyl-5,5,5-trifluoropentan-2-yl (meth)acrylate.

The proportion of the structural unit (III-2) contained with respect to the total structural units constituting the polymer (A) is preferably 0 mol% to 50 mol%, more preferably 0 mol% to 30 mol%, and still more preferably 10 mol% to 25 mol%. When the proportion is thus adjusted, the LWR performance of the radiation-sensitive resin composition can be further improved.

### Other Structural Unit

Also, the polymer (A) may have, for example, other structural unit such as a structural unit containing an alkali-soluble group, a structural unit containing at least one selected from the group consisting of a lactone structure, a cyclic carbonate structure and a sultone structure, and a structural unit containing an alicyclic group, in addition to the structural units described above. Examples of the alkali-soluble group include a carboxy group, a sulfonamide group, a sulfo group, and the like. As the structural unit containing at least one selected from the group consisting of a lactone structure, a cyclic carbonate structure and a sultone structure, a structural unit (C-II) in the polymer (C) described later and the like may be exemplified.

The proportion of the other structural unit contained with respect to the total structural units constituting the polymer (A) is typically no greater than 30 mol%, and preferably no greater than 20 mol%. When the proportion of the other structural unit contained is greater than the upper limit, the solubility in an alkaline developer solution of the polymer (A) at light-exposed sites is deteriorated, and as a result, rectangular configuration of the cross-sectional shape of the resist pattern formed from the radiation-sensitive resin composition may be impaired.

The lower limit of the content of the polymer (A) with respect to the total solid content in the radiation-sensitive resin composition is preferably 0.1 parts by mass, more preferably 0.5 parts by mass, still more preferably 1 part by mass, and particularly preferably 3 parts by mass. The upper limit of the content of the polymer (A) is preferably 30 parts by mass, more preferably 20 parts by mass, still more preferably 15 parts by mass, and particularly preferably 10 parts by mass.

In addition, the lower limit of the content of the polymer (A) with respect to 100 parts by mass of the polymer (C) described later is preferably 0.1 parts by mass, more preferably 0.5 parts by mass, still more preferably 1 part by mass, and particularly preferably 3 parts by mass. The upper limit of the content of the polymer (A) is preferably 30 parts by mass, more preferably 20 parts by mass, still more preferably 15 parts by mass, and particularly preferably 10 parts by mass.

When the content of the polymer (A) falls within the above range, the LWR performance, etc., of the radiation-sensitive resin composition can be further enhanced.

### Synthesis Method of Polymer (A)

The polymer (A) may be synthesized by, for example, polymerizing a monomer that gives each structural unit using a radical polymerization initiator in an appropriate solvent.

Examples of the radical polymerization initiator include: azo radical initiators such as azobisisobutyronitrile (AIBN), 2,2'-azobis(4-methoxy-2,4-dimethylvaleronitrile), 2,2'-azobis(2-cyclopropylpropionitrile), 2,2'-azobis(2,4-dimethylvaleronitrile) and dimethyl 2,2'-azobisisobutyrate; peroxide radical initiators such as benzoyl peroxide, t-butyl hydroperoxide and cumene hydroperoxide; and the like. Of these, AIBN and dimethyl 2,2'-azobisisobutyrate are preferred, and AIBN is more preferred. These radical polymerization initiators may be used either alone, or as a mixture of two or more types thereof.

Examples of the solvent for use in the polymerization include:
alkanes such as n-pentane, n-hexane, n-heptane, n-octane, n-nonane and n-decane;
cycloalkanes such as cyclohexane, cycloheptane, cyclooctane, decalin and norbomane;
aromatic hydrocarbons such as benzene, toluene, xylene, ethylbenzene and cumene;
halogenated hydrocarbons such as chlorobutanes, bromohexanes, dichloroethanes, hexamethylene dibromide and chlorobenzene;
saturated carboxylic acid esters such as ethyl acetate, n-butyl acetate, i-butyl acetate and methyl propionate;
ketones such as acetone, methylethylketone, 4-methyl-2-pentanone and 2-heptanone;
ethers such as tetrahydrofuran, dimethoxyethanes and diethoxyethanes;
alcohols such as methanol, ethanol, 1-propanol, 2-propanol and 4-methyl-2-pentanol; and the like. These solvents for use in the polymerization may be used either alone of one type, or in combination two or more types thereof.

The reaction temperature in the polymerization is typically 40 °C to 150 °C, and preferably 50 °C to 120 °C. The reaction time period is typically 1 hour to 48 hrs, and preferably 1 hour to 24 hrs.

Although the polystyrene equivalent weight average molecular weight (Mw) of the polymer (A) as determined by gel permeation chromatography (GPC) is not particularly limited the Mw is preferably no less than 1,000 and no greater than 50,000, more preferably no less than 2,000 and no greater than 30,000, still more preferably no less than 5,000 and no greater than 25,000, and particularly preferably no less than 7,000 and no greater than 20,000. When the Mw of the polymer (A) falls within the above range, coating properties and inhibitory ability of development defects of the radiation-sensitive resin composition can be improved.

The ratio (Mw/Mn) of the Mw to the polystyrene equivalent number average molecular weight (Mn) of the polymer (A) as determined on GPC is typically no less than 1 and no greater than 5, preferably 1 no less than and no greater than 3, and still more preferably no less than 1 and no greater than 2.

The Mw and the Mn of the polymer herein are values measured by using gel permeation chromatography (GPC) under the following conditions:
GPC column: Tosoh Corporation, "G2000HXL" x 2, "G3000HXL" x 1, and "G4000HXL" x 1;
column temperature: 40 °C;
elution solvent: Wako Pure Chemical Industries, Ltd., tetrahydrofuran;
flow rate: 1.0 mL/min;
sample concentration: 1.0% by mass;
amount of injected sample: 100 µL;
detector: differential refractometer; and
standard substance: mono-dispersed polystyrene.

### (B) Acid Generator

The acid generator (B) is a substance that generates an acid upon an exposure. The acid thus generated allows the acid-labile group included in the polymer (A), the polymer (C) described later and the like to be dissociated, thereby giving a carboxy group and the like. As a result, formation of the resist pattern is enabled. In the radiation-sensitive resin composition, the acid generator (B) may be contained either in the form of a low-molecular compound as described later (hereinafter, may be also referred to as "acid generating agent (B)" ad libitum), or in the form of an acid-generating group incorporated as a part of the polymer, or may be in both of these forms.

The acid generating agent (B) is exemplified by an onium salt compound, an N-sulfonyloxyimide compound, a halogen-containing compound, a diazo ketone compound, and the like.

Examples of the onium salt compound include sulfonium salts, tetrahydrothiophenium salts, iodonium salts, phosphonium salts, diazonium salts, pyridinium salts, and the like.

Specific examples of the acid generating agent (B) include the compounds disclosed in paragraphs [0080] to [0113] of Japanese Unexamined Patent Application, Publication No. 2009-134088, for example, and the like.

The acid generating agent (B) is preferably a compound represented by the following formula (3). When the acid generating agent (B) has the structure described below, it is believed that due to an interaction thereof, etc., with the polymer (A) and the polymer (C), the diffusion length of the acid, which is generated upon an exposure, in the resist film moderately would decrease, consequently, leading to a possibility of an improvement of the LWR performance, etc., of the radiation-sensitive resin composition.

R¹¹-R¹²-SO₃⁻ X⁺ (3)

In the above formula (3), R¹¹ represents a monovalent group containing an alicyclic structure having no less than 7 ring atoms or a monovalent group containing an aliphatic heterocyclic structure having no less than 7 ring atoms; R¹² represents a fluorinated alkanediyl group having 1 to 10 carbon atoms; and X⁺ represents a monovalent radioactive ray-labile onium cation.

Examples of the monovalent group containing an alicyclic structure having no less than 7 ring atoms which may be represented by R¹¹ include:
monocyclic cycloalkyl groups such as a cyclooctyl group, a cyclononyl group, a cyclodecyl group and a cyclododecyl group;
monocyclic cycloalkenyl groups such as a cyclooctenyl group and a cyclodecenyl group;
polycyclic cycloalkyl groups such as a norbornyl group, an adamantyl group, a tricyclodecyl group and a tetracyclododecyl group;
polycyclic cycloalkenyl groups such as a norbornenyl group and a tricyclodecenyl group;
groups containing an ester group such as a cyclooctylcarbonyloxy group, a norbomyloxycarbonyl group, an adamantylcarbonyloxy group or a hydroxyadamantyl methyloxycarbonyl group; and the like.

Examples of the monovalent group containing an aliphatic heterocyclic structure having no less than 7 ring atoms which may be represented by R¹¹ include:
groups containing a lactone structure such as a norbornanelacton-yl group;
groups containing a sultone structure such as a norbornanesulton-yl group;
oxygen atom-containing heterocyclic groups such as an oxacycloheptyl group and an oxanorbornyl group;
nitrogen atom-containing heterocyclic groups such as an azacycloheptyl group, and a diazabicyclooctan-yl group;
sulfur atom-containing heterocyclic groups such as a thiacycloheptyl group, and a thianorbornyl group; and the like.

In light of the diffusion length of the acid becoming furthermore adequate, the group represented by R¹¹ has ring atoms of preferably no less than 8, more preferably 9 to 15, and still more preferably 10 to 13.

Of these, R¹¹ represents preferably a monovalent group containing an alicyclic structure having at least 9 ring atoms, or a monovalent group containing an aliphatic heterocyclic structure having at least 9 ring atoms, more preferably a monovalent group containing an alicyclic structure having at least 9 ring atoms, still more preferably a group containing a polycyclic cycloalkyl group or an ester group, and particularly preferably an adamantyl group, an adamantylcarbonyloxy group or a hydroxyadamantylmethyloxycarbonyl group.

The fluorinated alkanediyl group having 1 to 10 carbon atoms represented by R¹² is exemplified by groups obtained by substituting at least one hydrogen atom included in the alkanediyl group having 1 to 10 carbon atoms such as a methanediyl group, an ethanediyl group or a propanediyl group with a fluorine atom, and the like.

Of these, fluorinated alkanediyl groups in which a fluorine atom is bound to the carbon atom adjacent to the SO₃⁻ group are preferred, fluorinated alkanediyl groups in which two fluorine atoms are bound to the carbon atom adjacent to the SO₃⁻group are more preferred, and a 1,1-difluoromethanediyl group, a 1,1-difluoroethanediyl group and a 1,1,3,3,3-pentafluoro-1,2-propanediyl group are still more preferred.

The monovalent radioactive ray-labile onium cation represented by X⁺ is a cation that is degraded upon an irradiation with a radioactive ray. At light-exposed sites, a sulfonic acid is generated from the sulfonate anion and a proton generated through the degradation of the radioactive ray-labile onium cation. The monovalent radioactive ray-labile onium cation represented by X⁺ is exemplified by a radioactive ray-labile onium cation containing an element such as S, I, O, N, P, Cl, Br, F, As, Se, Sn, Sb, Te or Bi. Examples of the cation that contains S (sulfur) as the element include a sulfonium cation, a tetrahydrothiophenium cation and the like, whereas examples of the cation that contains I (iodine) as the element include an iodonium cation and the like. Of these, sulfonium cations represented by the following formula (X-1), tetrahydrothiophenium cations represented by the following formula (X-2), and iodonium cations represented by the following formula (X-3) are preferred.

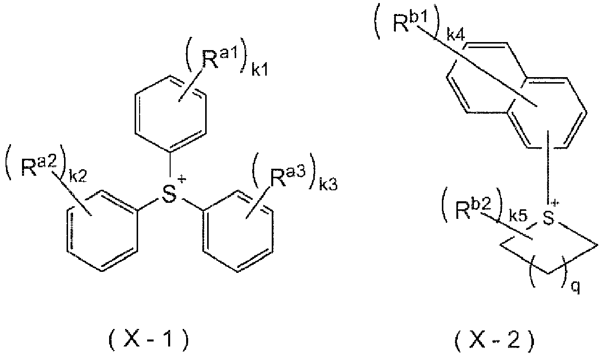

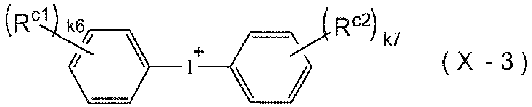

In the above formula (X-1), R^{a1}, R^{a2} and R^{a3} each independently represent a substituted or unsubstituted linear or branched alkyl group having 1 to 12 carbon atoms, a substituted or unsubstituted aromatic hydrocarbon group having 6 to 12 carbon atoms, -OSO₂-R^{P} or -SO₂-R^{Q}, or at least two of these groups taken together represent a ring structure; R^{P} and R^{Q} each independently represent a substituted or unsubstituted linear or branched alkyl group having 1 to 12 carbon atoms, a substituted or unsubstituted alicyclic hydrocarbon group having 5 to 25 carbon atoms or a substituted or unsubstituted aromatic hydrocarbon group having 6 to 12 carbon atoms; k1, k2 and k3 are each independently an integer of 0 to 5, wherein in a case in which R^{a1} to R^{a3}, and R^{P} and R^{Q} are each present in a plurality of number, a plurality of R^{a1}s to a plurality of R^{a3}s, and a plurality of R^{P}s and a plurality of R^{Q}s may be each identical or different with each other.

In the above formula (X-2), R^{b1} represents a substituted or unsubstituted linear or branched alkyl group having 1 to 8 carbon atoms, or a substituted or unsubstituted aromatic hydrocarbon group having 6 to 8 carbon atoms; k4 is an integer of 0 to 7, wherein in a case in which R^{b1} is present in a plurality of number, a plurality of R^{b1}s may be identical or different, and a plurality of R^{b1}s may taken together represent a ring structure; R^{b2} represents a substituted or unsubstituted linear or branched alkyl group having 1 to 7 carbon atoms, or a substituted or unsubstituted aromatic hydrocarbon group having 6 or 7 carbon atoms; k5 is an integer of 0 to 6, wherein in a case in which R^{b2} is present in a plurality of number, a plurality of R^{b2}s may be identical or different, and a plurality of R^{b2}s may taken together represent a ring structure; and q is an integer of 0 to 3.

In the above formula (X-3), R^{c1} and R^{c2} each independently represent a substituted or unsubstituted linear or branched alkyl group having 1 to 12 carbon atoms, a substituted or unsubstituted aromatic hydrocarbon group having 6 to 12 carbon atoms, -OSO₂-R^{R} or -SO₂-R^{S}, or at least two of these groups taken together represent a ring structure; R^{R} and R^{S} each independently represent a substituted or unsubstituted linear or branched alkyl group having 1 to 12 carbon atoms, a substituted or unsubstituted alicyclic hydrocarbon group having 5 to 25 carbon atoms or a substituted or unsubstituted aromatic hydrocarbon group having 6 to 12 carbon atoms; k6 and k7 are each independently an integer of 0 to 5, wherein in a case in which R^{c1}, R^{c2}, R^{R} and R^{S} are each present in a plurality of number, a plurality of R^{c1}s, a plurality of R^{c2}s, a plurality of R^{R}s and a plurality of R^{S}s may be each identical or different with each other.

Examples of the unsubstituted linear alkyl group which may be represented by R^{a1} to R^{a3}, R^{b1}, R^{b2}, R^{c1} and R^{c2} include a methyl group, an ethyl group, a n-propyl group, a n-butyl group, and the like.

Examples of the unsubstituted branched alkyl group which may be represented by R^{a1} to R^{a3}, R^{b1}, R^{b2}, R^{c1} and R^{c2} include an i-propyl group, an i-butyl group, a sec-butyl group, a t-butyl group, and the like.

Examples of the unsubstituted aromatic hydrocarbon group which may be represented by R^{a1} to R^{a3}, R^{c1} and R^{c2} include: aryl groups such as a phenyl group, a tolyl group, a xylyl group, a mesityl group and a naphthyl group; aralkyl groups such as a benzyl group and a phenethyl group; and the like.

Examples of the unsubstituted aromatic hydrocarbon group which may be represented by R^{b1} and R^{b2} include a phenyl group, a tolyl group, a benzyl group, and the like.

Examples of the substituent which may substitute for the hydrogen atom included in the alkyl group and the aromatic hydrocarbon group include halogen atoms such as a fluorine atom, a chlorine atom, a bromine atom and an iodine atom, a hydroxy group, a carboxy group, a cyano group, a nitro group, an alkoxy group, an alkoxycarbonyl group, an alkoxycarbonyloxy group, an acyl group, an acyloxy group, and the like.

Of these, the halogen atoms are preferred, and a fluorine atom is more preferred.

R^{a1} to R^{a3}, R^{b1}, R^{b2}, R^{c1} and R^{c2} described above represent preferably an unsubstituted linear or branched alkyl group, a fluorinated alkyl group, an unsubstituted monovalent aromatic hydrocarbon group, -OSO₂-R" or -SO₂-R", more preferably a fluorinated alkyl group or an unsubstituted monovalent aromatic hydrocarbon group, and still more preferably a fluorinated alkyl group. R" represents an unsubstituted monovalent alicyclic hydrocarbon group or an unsubstituted monovalent aromatic hydrocarbon group.

In the above formula (X-1), k1, k2 and k3 are preferably an integer of 0 to 2, more preferably 0 or 1, and still more preferably 0.

In the above formula (X-2), k4 is preferably an integer of 0 to 2, more preferably 0 or 1, and still more preferably 1, whereas k5 is preferably an integer of 0 to 2, more preferably 0 or 1, and still more preferably 0.

In the above formula (X-3), k6 and k7 are preferably an integer of 0 to 2, more preferably 0 or 1, and still more preferably 0.

Examples of the acid generating agent represented by the above formula (3) include compounds represented by the following formulae (3-1) to (3-11) (hereinafter, may be also referred to as "compounds (3-1) to (3-11)"), and the like.

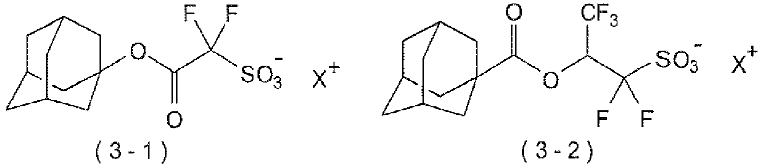

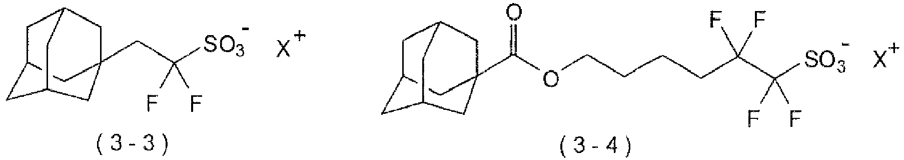

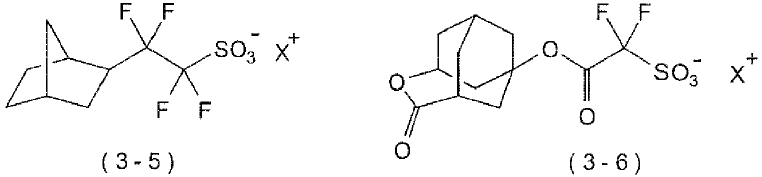

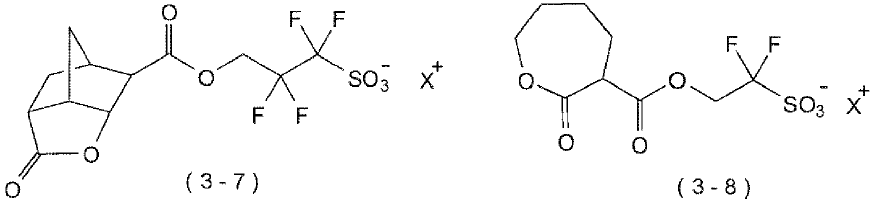

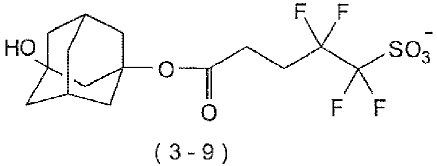

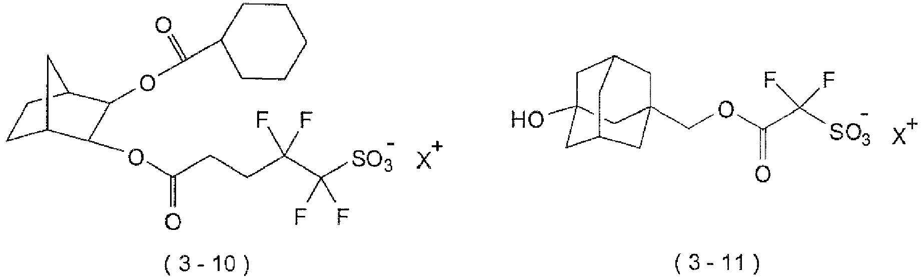

In the above formulae (3-1) to (3-11), X⁺ is as defined in the above formula (3).

Of these, the acid generating agent (B) is preferably an onium salt compound, more preferably a sulfonium salt, or a tetrahydrothiophenium salt, and still more preferably the compound (3-2), the compound (3-3) or the compound (3-11).

The content of the acid generator (B) is, when the acid generator (B) is the acid generating agent (B), with respect to 100 parts by mass of the polymer (A), preferably no less than 2 parts by mass and no greater than 600 parts by mass, more preferably no less than 10 parts by mass and no greater than 400 parts by mass, still more preferably no less than 20 parts by mass and no greater than 300 parts by mass, and particularly preferably no less than 60 parts by mass and no greater than 200 parts by mass.

Also, the content of the acid generating agent (B) with respect to 100 parts by mass of the polymer (C) described later is preferably no less than 0.1 parts by mass and no greater than 30 parts by mass, more preferably no less than 0.5 parts by mass and no greater than 20 parts by mass, still more preferably 1 part by mass and no greater than 15 parts by mass, and particularly preferably no less than 3 parts by mass and no greater than 10 parts by mass.

When the content of the acid generating agent (B) falls within the above range, the sensitivity and developability of the radiation-sensitive resin composition can be adequately adjusted, and as a result, the LWR performance, etc., can be improved. The acid generator (B) may be used of one type alone, or two or more types in combination.

### (C) Polymer

The polymer (C) is different from the polymer (A), and has an acid-labile group-containing structural unit. The radiation-sensitive resin composition typically contains the polymer (C). The polymer (C) constitutes a base polymer in the radiation-sensitive resin composition. The " base polymer" as referred to means a polymer that is included as a principal component of the polymer constituting the resist pattern formed from the radiation-sensitive resin composition, and preferably, a polymer that will account for no less than 50% by mass with respect to the total polymer constituting the resist pattern.

The polymer (C) preferably has, in addition to an acid-labile group-containing structural unit (hereinafter, may be also referred to as "structural unit (C-I)"), a structural unit containing at least one selected from the group consisting of a lactone structure, a cyclic carbonate structure and a sultone structure (hereinafter, may be also referred to as "structural unit (C-II)"), and further, may also have other structural unit except for the structural units (C-I) and (C-II).

### Structural Unit (C-I)

The structural unit (C-I) is the acid-labile group-containing structural unit. When the polymer (C) in the radiation-sensitive resin composition has the structural unit (C-I), the sensitivity and the resolution are improved, and as a result, the LWR performance, etc., can be improved. The structural unit (C-I) is exemplified by the structural unit (II), and the like in the polymer (A).

The proportion of the structural unit (C-I) contained with respect to the total structural units constituting the polymer (C) is preferably 20 mol% to 90 mol%, more preferably 30 mol% to 75 mol%, and still more preferably 35 mol% to 65 mol%. When the proportion of the structural unit (C-I) falls within the above range, the LWR performance of the radiation-sensitive resin composition can be improved.

### Structural Unit (C-II)

The structural unit (C-II) is a structural unit containing at least one selected from the group consisting of a lactone structure, a cyclic carbonate structure and a sultone structure. When the polymer (C) further has the structural unit (C-II) in addition to the structural unit (C-I), the solubility in a developer solution can be adjusted, and as a result, the LWR performance, etc., of the radiation-sensitive resin composition can be improved. Moreover, the adhesiveness of the resist pattern formed from the radiation-sensitive resin composition to the substrate can be improved.

Examples of the structural unit (C-II) include structural units represented by the following formulae, and the like.

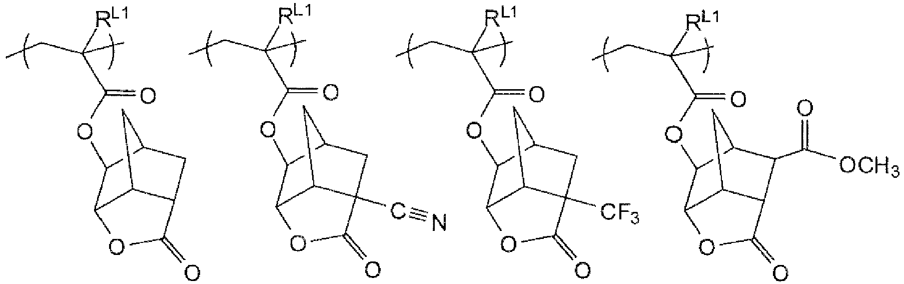

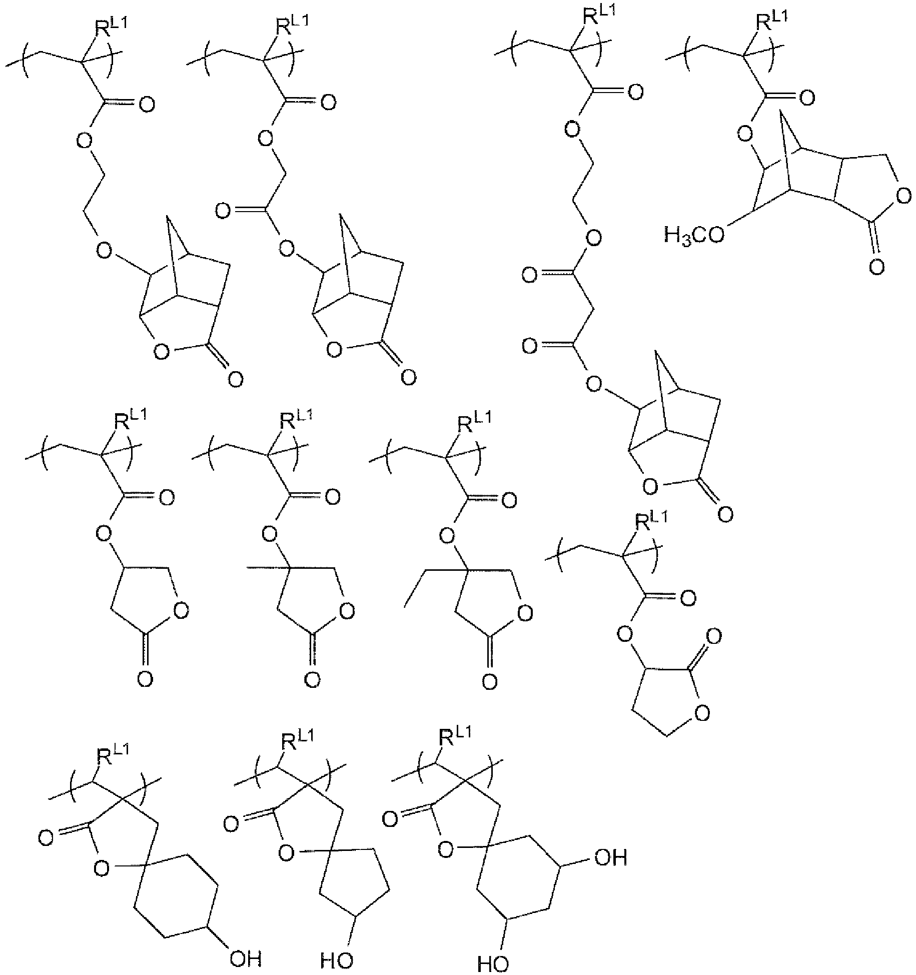

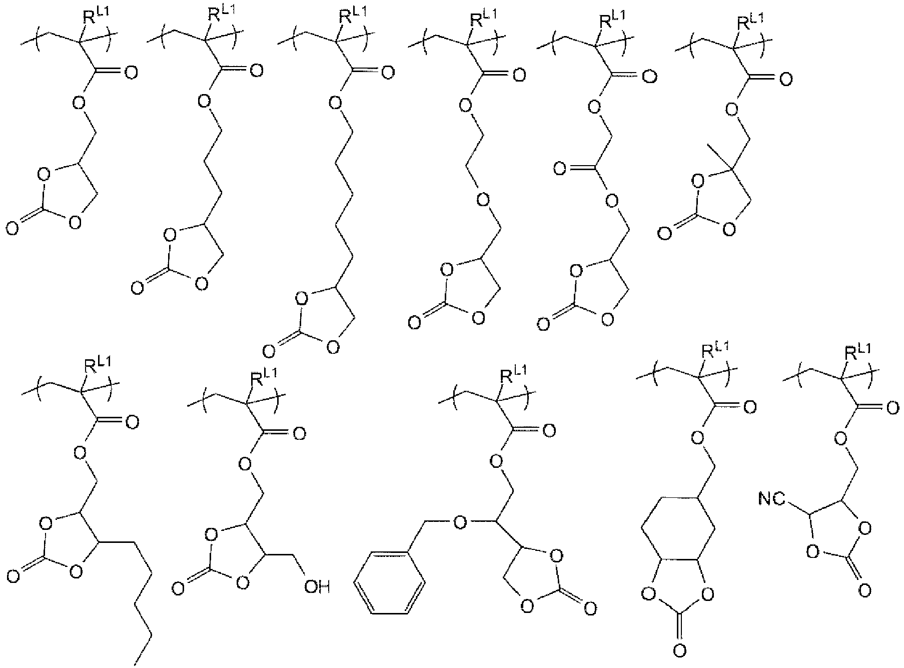

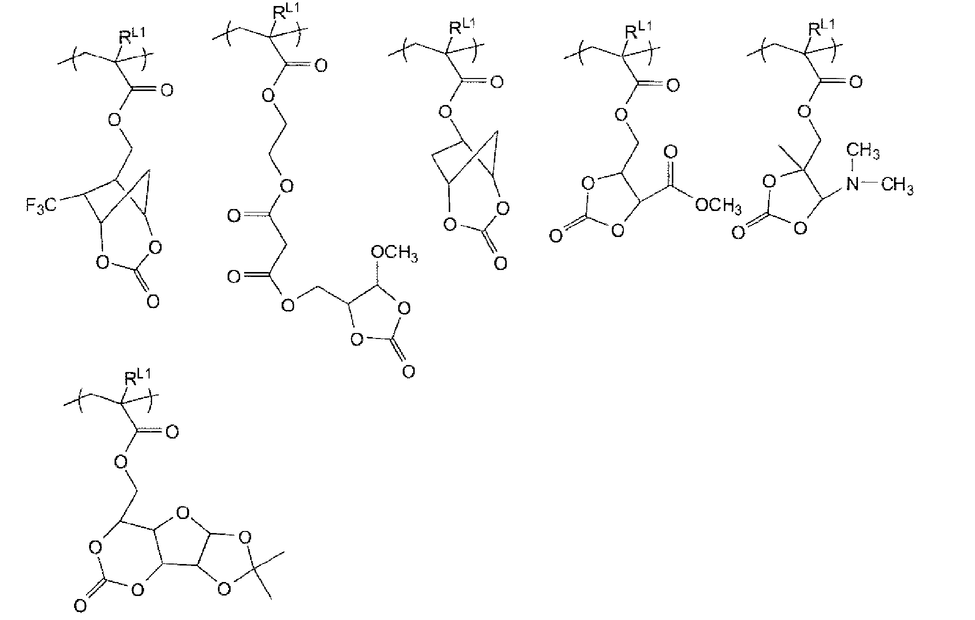

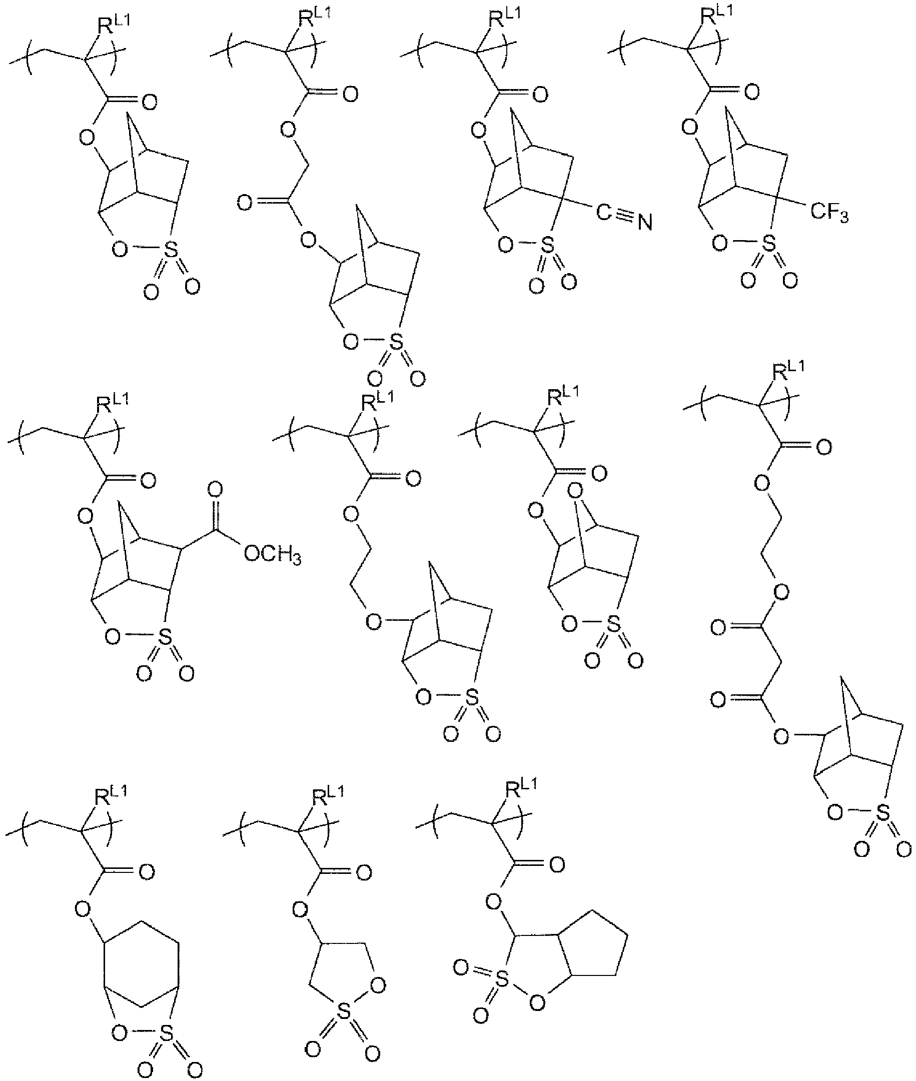

In the above formulae, R^{L1} represents a hydrogen atom, a fluorine atom, a methyl group or a trifluoromethyl group.

Of these, the structural unit (C-II) is preferably a structural unit containing a norbomanelactone structure, a structural unit containing a y-butyrolactone structure, a structural unit containing an ethylene carbonate structure, or a structural unit containing a norbornanesultone structure, more preferably the structural unit containing a norbomanelactone structure or the structural unit containing a γ-butyrolactone structure, and still more preferably a structural unit derived from norbomanelacton-yl (meth)acrylate, a structural unit derived from cyano substituted norbornanelacton-yl (meth)acrylate, a structural unit derived from γ-butyrolacton-yl (meth)acrylate or a structural unit derived from γ-butyrolacton-ylcyclohexanediyl (meth)acrylate.

The proportion of the structural unit (C-II) contained with respect to the total structural units constituting the polymer (C) is preferably 0 mol% to 80 mol%, more preferably 10 mol% to 70 mol%, and still more preferably 30 mol% to 65 mol%. When the proportion falls(within the above range, the adhesiveness of the resist pattern formed from the radiation-sensitive resin composition to the substrate can be further improved.

### Other Structural Unit

The polymer (C) may have other structural unit except for the structural units (C-I) and (C-II) described above. The other structural unit is exemplified by a structural unit containing a hydroxy group, and the like.

Examples of the structural unit containing a hydroxy group include structural units represented by the following formulae, and the like.

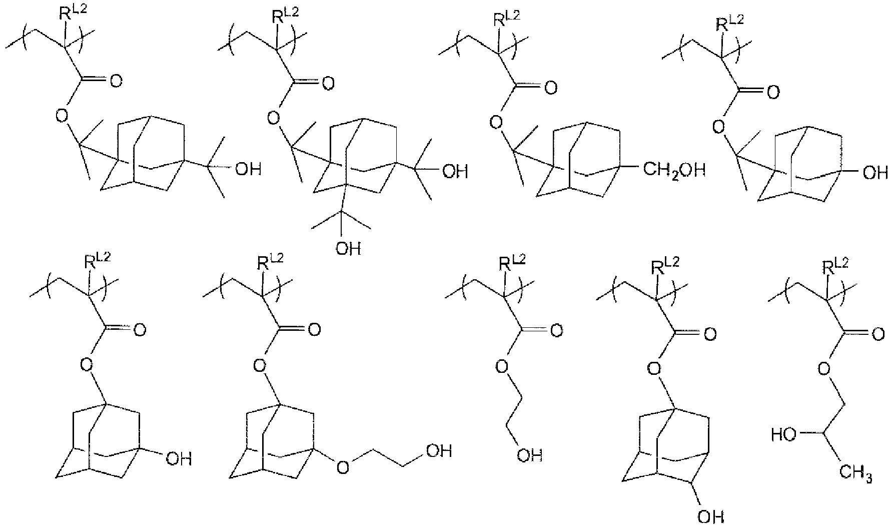

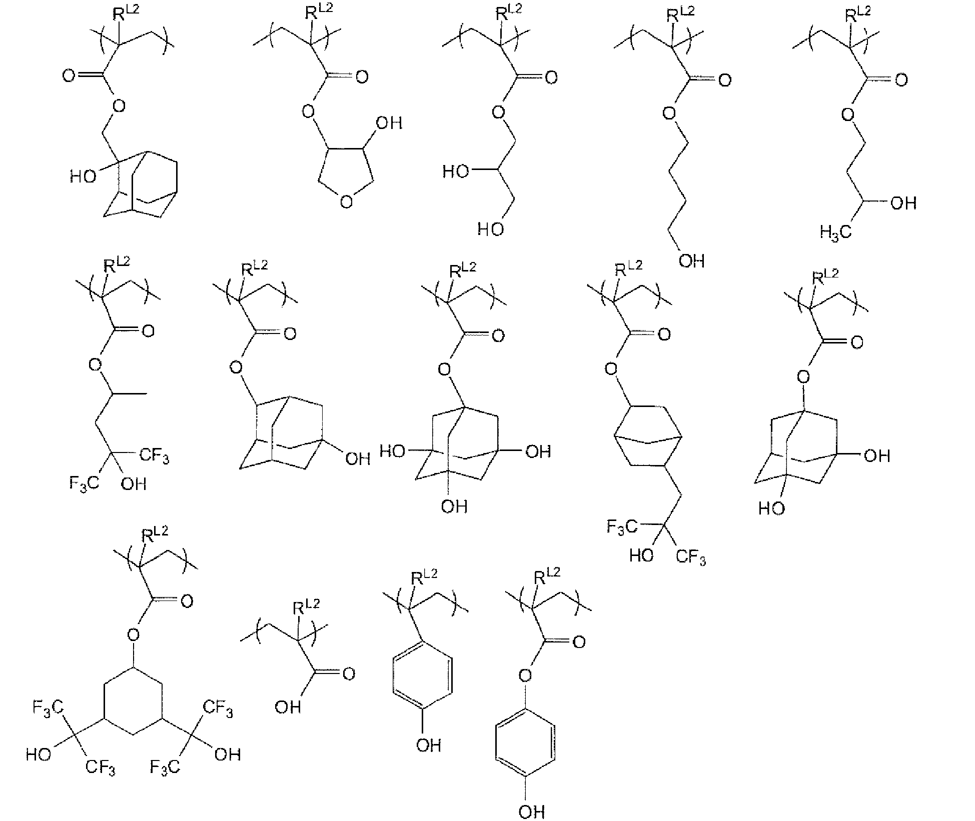

In the above formulae, R^{L2} represents a hydrogen atom, a fluorine atom, a methyl group or a trifluoromethyl group.

The proportion of the structural unit containing a hydroxy group with respect to the total structural units constituting the polymer (C) is preferably no greater than 30 mol%, and more preferably no greater than 20 mol%. When the proportion is greater than the upper limit, the pattern formability of the radiation-sensitive resin composition may be deteriorated.

The polymer (C) may also have other structural unit in addition to the structural units described above. The proportion of the other structural unit is preferably no greater than 20 mol%, and more preferably no greater than 10 mol%.

The content of the polymer (C) with respect to 100 parts by mass of the polymer (A) is preferably 300 parts by mass to 100,000 parts by mass, more preferably 500 parts by mass to 20,000 parts by mass, still more preferably 700 parts by mass to 10,000 parts by mass, and particularly preferably 1,000 parts by mass to 3,000 parts by mass.

In addition, the content of the polymer (C) in the total solid content of the radiation-sensitive resin composition is preferably no less than 70% by mass, more preferably no less than 80% by mass, and still more preferably no less than 85% by mass.

When the content of the polymer (C) falls within the above range, uneven distribution of the polymer (A) on the resist film surface layer can be further facilitated, and as a result, the LWR performance, etc., of the radiation-sensitive resin composition can be improved.

### (D) Acid Diffusion Controller

The radiation-sensitive resin composition may contain, as needed, the acid diffusion controller (D).

The acid diffusion controller (D) exerts the effect of controlling a phenomenon of diffusion of the acid, which was generated from the acid generator (B), in the resist film upon the exposure, and inhibiting unwanted chemical reactions in an unexposed region, whereby the storage stability of the resulting radiation-sensitive resin composition is further improved. Furthermore, resolution for use as a resist is further improved, while variation of the line width of the resist pattern caused by variation of post-exposure time delay from the exposure until a development treatment can be suppressed, which enables the radiation-sensitive resin composition with superior process stability to be obtained. The acid diffusion controller (D) may be contained in the radiation-sensitive resin composition either in the form of a free compound (hereinafter, may be also referred to as "(D) acid diffusion control agent" or "acid diffusion control agent (D)", as appropriate) or in the form incorporated as a part of the polymer, or may be in both of these forms.

The acid diffusion control agent (D) is exemplified by a compound represented by the following formula (4) (hereinafter, may be also referred to as "nitrogen-containing compound (I)"), a compound having two nitrogen atoms in the same molecule (hereinafter, may be also referred to as "nitrogen-containing compound (II)"), a compound having three nitrogen atoms (hereinafter, may be also referred to as "nitrogen-containing compound (III)"), an amide group-containing compound, a urea compound, a nitrogen-containing heterocyclic compound, and the like.

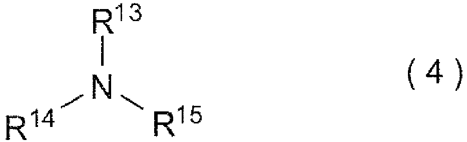

In the above formula (4), R¹³, R¹⁴ and R¹⁵ each independently represent a hydrogen atom, an unsubstituted or substituted linear, branched or cyclic alkyl group, an aryl group or an aralkyl group.

Examples of the nitrogen-containing compound (I) include: monoalkylamines such as n-hexylamine; dialkylamines such as di-n-butylamine; trialkylamines such as triethylamine; aromatic amines such as aniline; and the like.

Examples of the nitrogen-containing compound (II) include ethylenediamine, N,N,N',N'-tetramethylethylene diamine, and the like.

Examples of the nitrogen-containing compound (III) include: polyamine compounds such as polyethylene imine and polyallylamine; polymers such as dimethylaminoethylacrylamide, and the like.

Examples of the amide group-containing compound include formamide, N-methylfoumamide, N,N-dimethylformamide, acetamide, N-methylacetamide, N,N-dimethylacetamide, propionamide, benzamide, pyrrolidone, N-methylpyitolidone, and the like.

Examples of the urea compound include urea, methylurea, 1,1-dimethylurea, 1,3-dimethylurea, 1,1,3,3-tetramethylurea, 1,3-diphenylurea, tributylthiourea, and the like.

Examples of the nitrogen-containing heterocyclic compound include: pyridines such as pyridine and 2-methylpyridine; morpholines such as N-propylmorpholine and N-(undecylcarbonyloxyethyl)morpholine; pyrazine, pyrazole, and the like.

Also, as the nitrogen-containing heterocyclic compound, a compound having an acid-labile group may be used. Examples of the nitrogen-containing heterocyclic compound having an acid-labile group include N-t-butoxycarbonylpiperidine, N-t-butoxycarbonylimidazole, N-t-butoxycarbonylbenzimidazole, N-t-butoxycarbonyl-2-phenylbenzimidazole, N-(t-butoxycarbonyl)di-n-octylamine, N-(t-butoxycarbonyl)diethanolamine, N-(t-butoxycarbonyl)dicyclohexylamine, N-(t-butoxycarbonyl)diphenylamine, N-t-butoxycarbonyl-4-hydroxypiperidine, N-t-amyloxycarbonyl-4-hydroxypiperidine, and the like.

Of these, the acid diffusion control agent (D) is preferably the nitrogen-containing heterocyclic compound, more preferably the morpholines, the nitrogen-containing heterocyclic compound having an acid-labile group, and still more preferably N-(undecylcarbonyloxyethyl)morpholine or N-t-alkyloxycarbonyl-4-hydroxypiperidine.

In addition, a photodegradable base which is sensitized upon an exposure to generate a weak acid can be also used as the acid diffusion control agent (D). The photodegradable base is exemplified by an onium salt compound and the like that loses acid diffusion controllability through degradation upon an exposure. Examples of the onium salt compound include a sulfonium salt compound represented by the following formula (5-1), and an iodonium salt compound represented by the following formula (5-2), and the like.

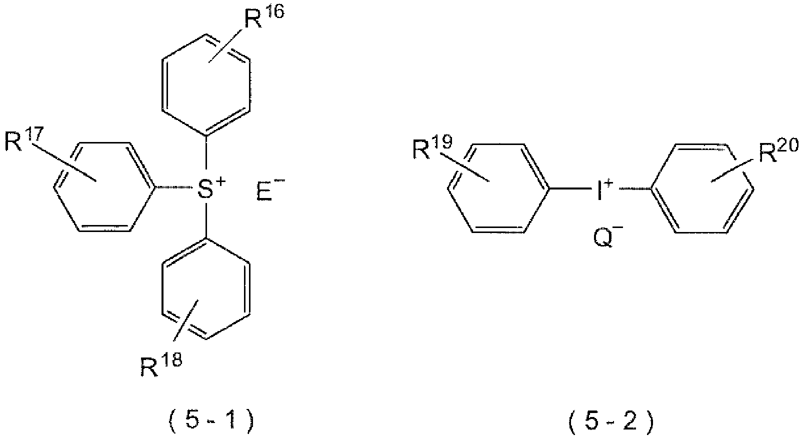

In the above formulae (5-1) and (5-2), R¹⁶ to R²⁰ each independently represent a hydrogen atom, an alkyl group, an alkoxy group, a hydroxy group or a halogen atom; E- and Q- each independently represent OH-, R^{β}-COO-, R^{β}-SO₃⁻ or an anion represented by the following formula (5-3), wherein R^{β} represents an alkyl group, an aryl group or aralkyl group.

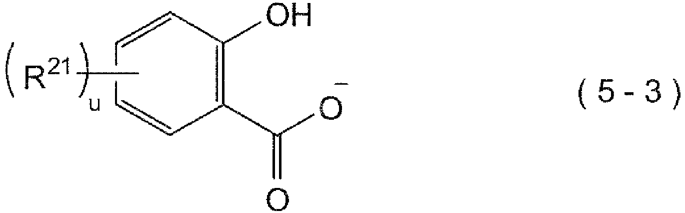

In the above formula (5-3), R²¹ represents a linear or branched alkyl group having 1 to 12 carbon atoms, or a linear or branched alkoxyl group having 1 to 12 carbon atoms, wherein a part or all of hydrogen atoms included in the linear or branched alkyl group or the linear or branched alkoxyl group may be substituted with a fluorine atom; and u is an integer of 0 to 2.

Examples of the photodegradable base include compounds represented by the following formulae, and the like.

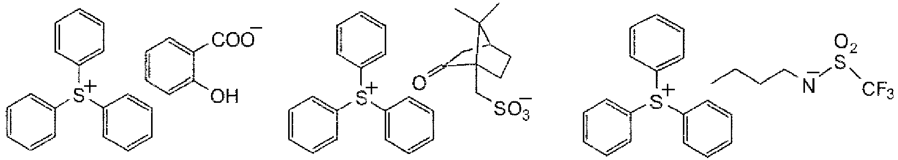

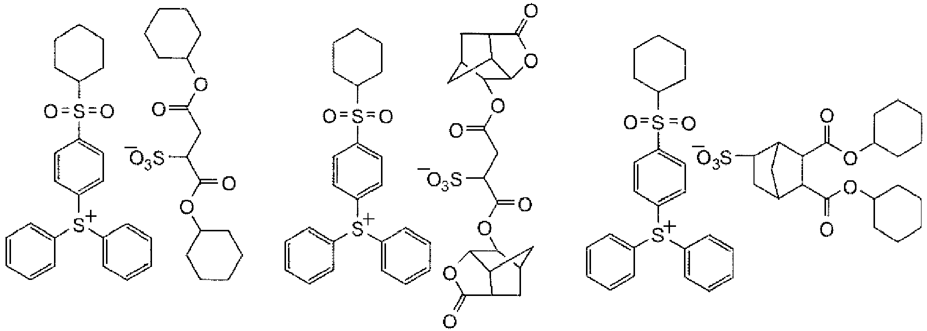

Of these, the photodegradable base is preferably a sulfonium salt, more preferably a triaryl sulfonium salt, still more preferably triphenylsulfonium salicylate or triphenylsulfonium 10-camphorsulfonate, and particularly preferably triphenylsulfonium 10-camphorsulfonate.

In the case of the acid diffusion controller (D) being the acid diffusion control agent (D), the content of the acid diffusion controller (D) with respect to 100 parts by mass of the polymer (A) is preferably 0 parts by mass to 400 parts by mass, more preferably 2 parts by mass to 300 parts by mass, and still more preferably 6 parts by mass to 200 parts by mass.

Also, the content of the acid diffusion controller (D) with respect to 100 parts by mass of the polymer (C) is preferably 0 parts by mass to 20 parts by mass, more preferably 0.1 parts by mass to 15 parts by mass, and still more preferably 0.3 parts by mass to 10 parts by mass.

When the content of the acid diffusion control agent (D) falls within the above range, the LWR performance, etc., of the radiation-sensitive resin composition can be improved.

### (E) Solvent

The radiation-sensitive resin composition typically contains (E) a solvent. The solvent (E) is not particularly limited as long as it is capable of dissolving or dispersing at least the polymer (A) and the acid generator (B), as well as the polymer (C), etc., contained as desired.

The solvent (E) is exemplified by an alcohol solvent, an ether solvent, a ketone organic solvent, an amide solvent, an ester organic solvent, a hydrocarbon solvent, and the like.

Examples of the alcohol solvent include:
aliphatic monohydric alcohol solvents having 1 to 18 carbon atoms such as 4-methyl-2-pentanol and n-hexanol;
alicyclic monohydric alcohol solvents having 3 to 18 carbon atoms such as cyclohexanol;
polyhydric alcohol solvents having 2 to 18 carbon atoms such as 1,2-propylene glycol;
polyhydric alcohol partial ether solvents having 3 to 19 carbon atoms such as propylene glycol monomethyl ether; and the like.

Examples of the ether solvent include:
dialkyl ether solvents such as diethyl ether, dipropyl ether and dibutyl ether;
cyclic ether solvents such as tetrahydrofuran and tetrahydropyran;
aromatic ring-containing ether solvents such as diphenyl ether and anisole (methyl phenyl ether); and the like.

Examples of the ketone solvent include:
chain ketone solvents such as acetone, methyl ethyl ketone, methyl-n-propyl ketone, methyl-n-butyl ketone, diethyl ketone, methyl-iso-butyl ketone, 2-heptanone, ethyl-n-butyl ketone, methyl-n-hexyl ketone, di-iso-butyl ketone and trimethylnonanone:
   cyclic ketone solvents such as cyclopentanone, cyclohexanone, cycloheptanone, cyclooctanone and methylcyclohexanone:
2,4-pentanedione, acetonylacetone, acetophenone; and the like.

Examples of the amide solvent include:
cyclic amide solvents such as N,N'-dimethylimidazolidinone and N-methylpyrrolidone;
chain amide solvents such as N-methylformamide, N,N-dimethylformamide, N,N-diethylformamide, acetamide, N-methylacetamide, N,N-dimethylacetamide and N-methylpropionamide; and the like.

Examples of the ester solvent include:
monocarboxylic acid ester solvents such as ester acetates, e.g., n-butyl acetate;
polyhydric alcohol carboxylate solvents such as propylene glycol acetate;
polyhydric alcohol partial ether carboxylate solvents such as polyhydric alcohol partial alkyl ether acetates, e.g., propylene glycol monomethyl ether acetate;
polyvalent carboxylic acid diester solvents such as diethyl oxalate;
lactone solvents such as γ-butyrolactone and δ-valerolactone;
carbonate solvents such as diethyl carbonate, ethylene carbonate and propylene carbonate; and the like.

The hydrocarbon solvent is exemplified by a linear or branched chain hydrocarbon having 5 to 10 carbon atoms, an alicyclic hydrocarbon having 5 to 12 carbon atoms, an aromatic hydrocarbon having 6 to 18 carbon atoms, and the like. A part or all of hydrogen atoms on the ring of the alicyclic hydrocarbon and the aromatic hydrocarbon may be substituted with a linear or branched alkyl group having 1 to 5 carbon atoms.

Of these, the ester solvents and the ketone solvents are preferred, the polyhydric alcohol partial ether carboxylate solvent, the cyclic ketone solvent, and the lactone solvent are more preferred, and propylene glycol monomethyl ether acetate and cyclohexanone, γ-butyrolactone are still more preferred. The radiation-sensitive resin composition may contain one, or two or more types of the solvent (E).

### Other Optional Components

The radiation-sensitive resin composition may contain other optional component, in addition to (A) to (E) described above. The other optional component is exemplified by a surfactant, an alicyclic skeleton-containing compound, a sensitizing agent, and the like. One, or two or more types in combination of these other optional components may be used.

### Surfactant

The surfactant exerts the effect of improving coating property, striation, developability, and the like. Examples of the surfactant include: nonionic surfactants such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate and polyethylene glycol distearate; and the like, as well as commercially available products such as: KP341 (Shin-Etsu Chemical Co., Ltd.), Polyflow No. 75 and Polyflow No. 95 (all Kyoeisha Chemical Co., Ltd.), EFTOP EF301, EFTOP EF303 and EFTOP EF352 (all Tochem Products Co. Ltd.), Megaface F171 and Megaface F173 (all DIC, Corporation), Fluorad FC430 and Fluorad FC431 (all Sumitomo 3M Limited), ASAHI GUARD AG710, Surflon S-382, Surflon SC-101, Surflon SC-102, Surflon SC-103, Surflon SC-104, Surflon SC-105 and Surflon SC-106 (all Asahi Glass Co., Ltd.); and the like. The content of the surfactant in the radiation-sensitive resin composition with respect to 100 parts by mass of the polymer (A) is typically no greater than 40 parts by mass.

### Alicyclic Skeleton-Containing Compound

The alicyclic skeleton-containing compound exerts the effect of improving the dry etching resistance, the pattern configuration, the adhesiveness to the substrate, and the like.

Examples of the alicyclic skeleton-containing compound include:
adamantane derivatives such as 1-adamantanecarboxylic acid, 2-adamantanone and t-butyl 1-adamantanecarboxylate;
deoxycholic acid esters such as t-butyl deoxycholate, t-butoxycarbonylmethyl deoxycholate and 2-ethoxyethyl deoxycholate;
lithocholic acid esters such as t-butyl lithocholate, t-butoxycarbonylmethyl lithocholate and 2-ethoxyethyl lithocholate;
3-[2-hydroxy-2,2-bis(trifluoromethyl)ethyl]tetracyclo[4.4.0.1^{2,5}.1^{7,10}]dodecane, 12-hydroxy-9-methoxycarbonyl-5-oxo-4-oxa-tricyclo[4.2. 1.0³,⁷]nonane; and the like. The content of the alicyclic skeleton-containing compound in the radiation-sensitive resin composition with respect to 100 parts by mass of the polymer (A) is typically no greater than 100 parts by mass.

### Sensitizing Agent

The sensitizing agent exhibits the action of increasing the amount of the acid produced from the acid generating agent (B) and the like, and exerts the effect of improving "apparent sensitivity" of the radiation-sensitive resin composition.

Examples of the sensitizing agent include carbazoles, acetophenones, benzophenones, naphthalenes, phenols, biacetyl, eosin, rose bengal, pyrenes, anthracenes, phenothiazines, and the like. These sensitizing agent may be used either alone, or two or more types thereof may be used in combination. The content of the sensitizing agent in the radiation-sensitive resin composition with respect to 100 parts by mass of the polymer (A) is typically no greater than 40 parts by mass.

### Preparation Method of Radiation-Sensitive Resin Composition

The radiation-sensitive resin composition may be prepared, for example, by mixing the polymer (A), the acid generator (B), as well as the optional component such as the polymer (C) which may be added as needed, and the solvent (E) in a certain ratio. The radiation-sensitive resin composition is preferably filtered after the mixing, through a filter, etc., having a pore size of about 0.2 µm, for example. The solid content concentration of the radiation-sensitive resin composition is typically 0.1% by mass to 50% by mass, preferably 0.5% by mass to 30% by mass, and more preferably 1% by mass to 20% by mass.

### Resist Pattern-Forming Method

The resist pattern-forming method includes the steps of:
forming a resist film (hereinafter, may be also referred to as "resist film-forming step");
subjecting the resist film to liquid immersion lithography (hereinafter, may be also referred to as "liquid immersion lithography step"); and
developing the resist film subjected to the liquid immersion lithography (hereinafter, may be also referred to as "development step"),
in which the resist film is formed from the radiation-sensitive resin composition.

According to the resist pattern-forming method, since the aforementioned radiation-sensitive resin composition is used, a resist pattern having less LWR and CDU, and being accompanied by fewer defects can be formed while superior EL performances are exhibited. Hereinafter, each step will be described.

### Resist Film-Forming Step

In this step, a resist film is formed from the radiation-sensitive resin composition. A substrate on which the resist film is formed is exemplified by conventionally well-known substrates such as a silicon wafer, a wafer coated with silicon dioxide or aluminum, and the like. Also, an organic or inorganic antireflective film disclosed in, for example, Japanese Examined Patent Application, Publication No. H6-12452, Japanese Unexamined Patent Application, Publication No. S59-93448 and the like may be formed on the substrate. An application procedure is exemplified by spin-coating, cast coating, roll coating, and the like. After the application, prebaking (PB) may be executed as needed, in order to evaporate off the solvent in the coating film. A PB temperature is typically 60°C to 140°C, and preferably 80°C to 120°C. A PB time period is typically 5 sec to 600 sec, and preferably 10 sec to 300 sec. The thickness of the resist film formed is preferably 10 nm to 1,000 nm, and more preferably 10 nm to 500 nm.

### Liquid Immersion Lithography Step

In this step, the resist film formed in the above step is subjected to liquid immersion lithography. Specifically, an exposure is carried out by, for example, irradiation with a radioactive ray through a photomask and a liquid immersion medium,. In accordance with the line width of the intended pattern, the radioactive ray may be exemplified by: a visible light ray; an ultraviolet ray; a far ultraviolet ray such as an ArF excimer laser beam (wavelength: 193 nm) and a KrF excimer laser beam (wavelength: 248 nm); an electromagnetic wave such as an X-ray and a y- radiation; a charged particle ray such as an electron beam and an α-ray; and the like. Of these, a far ultraviolet ray, and an electron beam are preferred, an ArF excimer laser beam, a KrF excimer laser beam and an electron beam are more preferred, and an ArF excimer laser beam and an electron beam are still more preferred.

The liquid immersion liquid which may be employed is exemplified by water, a fluorine-containing inert liquid, and the like. It is preferred that the liquid immersion liquid is transparent to the exposure wavelength, and has a temperature coefficient of the refractive index as small as possible such that distortion of an optical image projected onto the film is minimized. In particular, when an ArF excimer laser beam (wavelength: 193 nm) is used as an exposure light source, water is preferably used in light of its availability and ease of handling, in addition to the aforementioned respects. When water is used as the liquid immersion liquid, a slight amount of an additive may be added which reduces the surface tension of water and provides surfactant power. It is preferred that the additive hardly dissolves the resist film on the wafer and has a negligible influence on an optical coating of an inferior face of a lens. Distilled water is preferably used.

After the exposure, it is preferred that post exposure baking (PEB) is executed to facilitate dissociation of the acid-labile group included in the polymer (A), the polymer (C), etc., at exposed region of the resist film, resulting from the acid generated from acid generator (B) upon an exposure. A PEB temperature is typically 50 °C to 180 °C, and preferably 80 °C to 130 °C. A PEB time period is typically 5 sec to 600 sec, and preferably 10 sec to 300 sec.

### Development Step

In this step, the resist film subjected to the liquid immersion lithography in the above step is developed. Accordingly, a predetermined resist pattern can be formed. The development is generally followed by washing with a rinse agent such as water, and drying.

As a developer solution for use in the development, an alkaline developer solution is typically used.

Examples of the alkaline developer solution include aqueous alkaline solutions prepared by dissolving at least one alkaline compound such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide (TMAH), pymole, piperidine, choline, 1,8-diazabicyclo-[5.4.0]-7-undecene, and 1,5-diazabicyclo-[4.3.0]-5-nonene; and the like. Of these, an aqueous TMAH solution is preferred, and a 2.38% by mass aqueous TMAH solution is more preferred.

Examples of the development procedure include: a dip method in which the substrate is immersed for a given time period in the developer solution charged in a container; a puddle method in which the developer solution is placed to form a dome-shaped bead by way of the surface tension on the surface of the substrate for a given time period to conduct a development; a spray method in which the developer solution is sprayed onto the surface of the substrate; a dynamic dispensing method in which the developer solution is continuously applied onto the substrate that is rotated at a constant speed while scanning with a developer solution-application nozzle at a constant speed; and the like.

### EXAMPLES

Hereinafter, the present invention is explained in detail by way of Examples, but, the present invention is not in any way limited to these Examples. Measuring methods for various types of physical properties are shown below.

### Mw and Mn

The Mw and the Mn of the polymer were measured by GPC, under the following conditions:
GPC column: Tosoh Corporation, "G2000HXL" x 2, "G3000HXL" x 1, and "G4000HXL" x 1;
column temperature: 40 °C;
elution solvent: tetrahydrofuran (manufactured by Wako Pure Chemical Industries, Ltd.);
flow rate: 1.0 mL/min;
sample concentration: 1.0% by mass;
amount of injected sample: 100 µL;
detector: differential refractometer; and
standard substance: mono-dispersed polystyrene.

### ¹³C-NMR Analysis

A ¹³C-NMR analysis was performed by using a nuclear magnetic resonance apparatus (JEOL, Ltd., "JNM-ECX400"), with deuterochloroform as a measurement solvent.

### Synthesis of Compounds

### Example 1: Synthesis of Compound (i-1)

Into a 500 mL three-neck flask in which nitrogen substitution had been executed, 8.8 g of sodium hydride (60% by mass in mineral oil), and 200 mL of tetrahydrofuran were charged, and the mixture was cooled on an ice bath such that the internal temperature was lowered to 0 °C. Then 31.6 g of t-butyl acetoacetate was slowly added dropwise such that the internal temperature was not elevated. After the completion of the dropwise addition, the mixture was stirred at 0 °C for 30 min. Thereafter, while the internal temperature was maintained at 0 °C, 36.3 g of α-bromo-γ-butyrolactone was slowly added dropwise, and after the completion of the dropwise addition, the internal temperature was elevated to 30 °C. The mixture was stirred at 30 °C overnight, and thereto was added 100 mL of 0.5 N hydrochloric acid to stop the reaction. An extraction operation from the reaction liquid was repeated three times using each 100 mL of dichloromethane, and thus recovered organic layers were collected, and concentrated in vacuo with an evaporator. Thus resulting residue was dissolved in 100 mL of acetonitrile, and thereto was added n-hexane. Then liquid separation was carried out to recover an acetonitrile layer, and vacuum concentration conducted with an evaporator gave tert-butyl 3-oxo-2-(2-oxooxolan-3-yl)butanoate. Next, the entirety of the product was transferred to a 500 mL three-neck flask, and dissolved in 200 mL of tetrahydrofuran. The internal temperature was lowered to 0 °C on an ice bath, and a solution was slowly added dropwise which had been prepared by dissolving 2.5 g of sodium borohydride in 20 g of water. The mixture was stirred at 0 °C for 3 hrs, and 100 mL of a saturated saline solution was added thereto, followed by three extraction operations with 100 mL of dichloromethane. The organic layers were collected, and concentrated in vacuo with an evaporator to obtain a residue. The entirety of the resulting residue was transferred to a 500 mL three-neck flask, and thereto were added 200 mL of acetonitrile, 0.03 g of dibutylhydroxytoluene and 20.24 g of triethylamine. The internal temperature of the mixture was lowered to 0 °C on an ice bath, then 20.91 g of methacryloyl chloride was slowly added dropwise, and the mixture was stirred for 4 hrs while the temperature was maintained at 0 °C. To the reaction liquid was added 200 mL of pure water, and three extraction operations were carried out with 100 mL of dichloromethane. The organic layers were collected, and purification by silica gel chromatography (developing solvent: ethyl acetate/ n-hexane = 1/4 (volume ratio)) gave 35.9 g of a synthesis intermediate represented by the following formula (ia-1) (yield: 55% (based on t-butyl acetoacetate)). Thus obtained synthesis intermediate (ia-1) was analyzed by LC-MS, and consequently ascertained that M⁺ was 326.1.

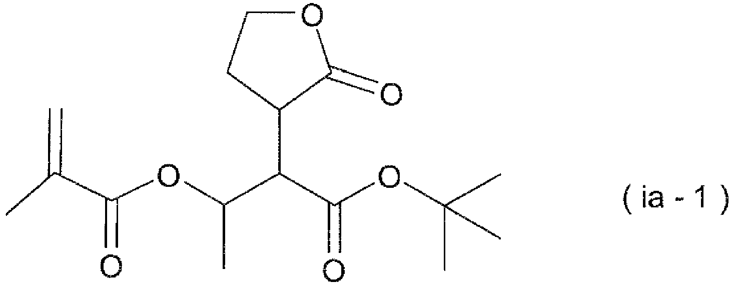

Next, 35.9 g of the compound (ia-1) synthesized as above was charged into a 500 mL three-neck flask in which nitrogen substitution had been executed, and dissolved in 200 mL of dichloromethane. Thereto was added 20 mL of trifluoroacetic acid, and the mixture was stirred at 23 °C for 3 hrs. Thereafter, the mixture was concentrated in vacuo with an evaporator, and 100 mL of toluene was added thereto. Then the mixture was again concentrated in vacuo to distill trifluoroacetic acid away. Thus resulting residue was dissolved in 100 mL of toluene, and thereto was added 0.4 g of N,N-dimethylformamide. While the mixture was stirred with a stirrer and the internal temperature was maintained at 23 °C, 20.9 g of oxalyl chloride was added over 30 min, and the mixture was further stirred for 2 hrs after the completion of the dropwise addition. Thereafter, the reaction liquid was concentrated in vacuo with an evaporator to distill off unreacted oxalyl chloride, and 100 mL of toluene was added to obtain a reaction product solution (A). Next, 100 mL of toluene, 22.2 g of 1,1,1,3,3,3-hexafluoro-2-propanol and 13.4 g of triethylamine were added to a 500 mL three-neck flask in which nitrogen substitution had been executed, and the mixture was stirred with a stirrer. The internal temperature was lowered to no greater than 5 °C on an ice bath. The reaction product solution (A) was slowly added dropwise over 1 hr, and stirring of the mixture was continued at 23 °C for 2 hrs after the completion of the dropwise addition. Thereafter, 200 mL of 1 N hydrochloric acid was added thereto, followed by stirring for 5 min, and the reaction liquid was transferred into a separatory funnel. A liquid separation operation was conducted to recover the organic layer (upper layer). After washing by liquid separation of thus obtained organic layer was repeated five times with 100 mL of pure water, the organic layer was vacuum concentrated with an evaporator to give 43.3 g of a crude product. Thus product was purified by silica gel column chromatography (developing solvent: ethyl acetate/ n-hexane = 1/4 (volume ratio)) to obtain 37.9 g of a compound (i-1) (a compound represented by the following formula (1-1)) (yield: 82% (based on the synthesis intermediate (ia-1))). Thus resultant compound (i-1) was analyzed by LC-MS, and consequently ascertained that M⁺ was 420.1.

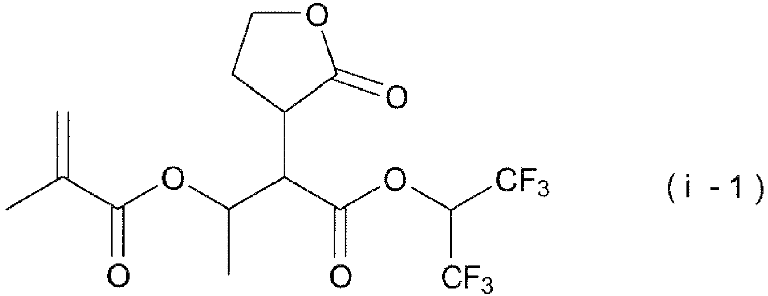

### Example 2: Synthesis of Compound (i-2)

Into a 200 mL three-neck flask in which nitrogen substitution had been executed, 10.8 g of methacryloyl chloride and 100 mL of dichloromethane were added, and the mixture was cooled on an ice bath to 0 °C. Hydroxyacetone in an amount of 7.4 g was slowly added dropwise such that the internal temperature was not elevated. Subsequently, 11.1 g of triethylamine was slowly added dropwise such that the internal temperature was not elevated. The mixture was stirred at 0 °C for 2 hrs, and disappearance of hydroxyacetone was confirmed on gas chromatography. Next, 100 mL of ultra pure water was added to the reaction liquid, and the mixture was stirred for 30 min. Thereafter, a liquid separation operation was conducted to recover an organic layer (underlayer). To thus recovered organic layer was added 100 mL of 0.2 N hydrochloric acid, and the liquid separation operation was conducted again to recover an organic layer (underlayer). Furthermore, the organic layer was washed with 50 mL of ultra pure water twice, and the recovered organic layer was concentrated in vacuo with an evaporator to recover a crude product. The crude product was purified by silica gel column chromatography (developing solvent: ethyl acetate/ n-hexane = 1/5 (volume ratio)) to obtain 12.7 g of 2-oxopropyl methacrylate (a compound represented by the following formula (ia-2)) (yield: 89% (based on hydroxyacetone)). Thus resultant 2-oxypropyl methacrylate was analyzed by LC-MS, and consequently ascertained that M⁺ was 142.06.

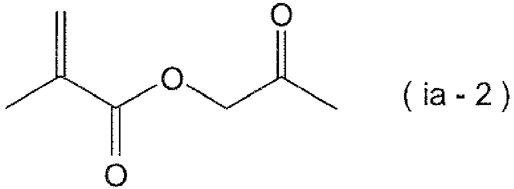

Into a 500 mL three-neck flask in which nitrogen substitution had been executed were added 3.9 g of zinc powder and 100 mL of tetrahydrofuran, and the mixture was stirred with a stirrer to prepare a suspension liquid. Thereto was added 0.05 g of trimethylsilyl chloride dropwise, and the mixture was stirred at 27 °C for 30 min. Thereafter, the internal temperature was elevated to 35 °C, and 50 mL of a solution containing 10.5 g of ethyl bromodifluorolacetate and 7.1 g of the compound (ia-2) synthesized as above (2-oxopropyl methacrylate) in tetrahydrofuran was slowly added dropwise over 1 hr. A reaction was allowed at 35 °C for 2 hrs, and after disappearance of 2-oxopropyl methacrylate was confirmed on gas chromatography, 100 mL of 1 N hydrochloric acid was added and the mixture was stirred for 30 min. A liquid separation operation was conducted to recover an organic layer, and the product was repeatedly extracted from the aqueous layer by using dichloromethane. Thus recovered dichloromethane layer was combined with the organic layer recovered first. The organic layer was washed with 100 mL of a 5% by mass aqueous sodium bicarbonate solution, and then washed with pure water three times. After thus recovered organic layer was vacuum concentrated with an evaporator, the residue was purified by silica gel column chromatography (developing solvent: ethyl acetate/ n-hexane = 1/1 (volume ratio)) to obtain 10.8 g of a compound (i-2) (a compound represented by the following formula (i-2)) (yield: 81% (based on 2-oxypropyl methacrylate)). Thus resultant compound (i-2) was analyzed by LC-MS, and consequently ascertained that M⁺ was 266.24.

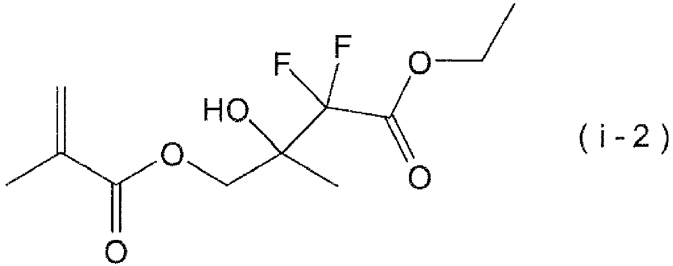

### Example 3: Synthesis of Compound (i-3)

Into a 1,000 mL three-neck flask in which nitrogen substitution had been executed were charged 68.65 g of zinc powder and 200 mL of tetrahydrofuran, and the mixture was stirred with a stirrer to prepare a suspension liquid. Thereto was added 5 mL of trimethylsilyl chloride dropwise, and the mixture was stirred at 30 °C for 30 min. Thereafter, the internal temperature was elevated to 35 °C, and a solution, which had been prepared by dissolving 152.24 g of ethyl bromodifluorolacetate and 75.09 g of 2-methyltetrahydrofuran-3-one in 100 mL of tetrahydrofuran, was added dropwise over 3 hrs. After completing the dropwise addition, the stirring was continued at 35 °C for 2 hrs, and then 500 mL of 3 N hydrochloric acid was added, followed by stirring for 30 min. The reaction liquid was transferred to a separatory funnel, and 500 mL of toluene was added thereto. Liquid separation was conducted to recover an organic layer (upper layer). The organic layer was washed once with 100 mL of a 5% by mass aqueous sodium bicarbonate solution, and thereafter washed with 100 mL of pure water five times. The organic layer was vacuum concentrated with an evaporator to give 122.6 g of a residue. Thus resulting residue was transferred to a 500 mL three-neck flask in which nitrogen substitution had been executed, and then the residue was dissolved in 300 mL of acetonitrile. The internal temperature was lowered to 5 °C on an ice bath, and 61.2 g of triethylamine was added to the mixture, then 63.2 g of methacryloyl chloride was added thereto dropwise over 30 min. After the internal temperature was adjusted to 23 °C and the mixture was stirred for 2 hrs, 300 mL of 1 N hydrochloric acid was added thereto and the mixture was stirred for 30 min. The reaction liquid was transferred to a separatory funnel, and a liquid separation operation was conducted to recover an organic layer (upper layer). Thus recovered organic layer was washed once with 100 mL of a 5% by mass aqueous sodium bicarbonate solution, and thereafter washed with 100 mL of pure water five times. The organic layer was vacuum concentrated with an evaporator to give 155.5 g of a residue. By subjecting thus resulting residue to vacuum distillation (1 mmHg, 125 °C), 133.5 g of a synthesis intermediate represented by the following formula (ia-3) was obtained. The synthesis intermediate (ia-3) was analyzed by LC-MS, and consequently ascertained that M⁺ was 292.1.

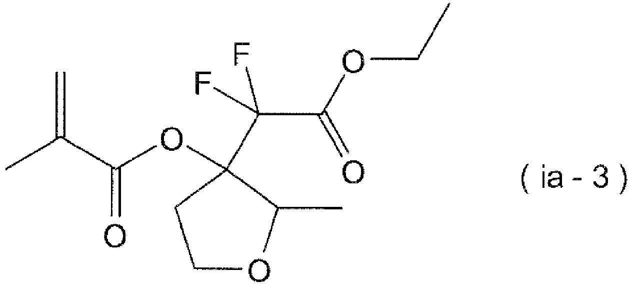

Into a 1,000 mL three-neck flask in which nitrogen substitution had been executed were added 13.1 g of lithium hydroxide and 120 g of pure water, and the mixture was stirred to permit dissolution. Thereto was added a solution over 5 min, which had been prepared by dissolving 133.5 g of the synthesis intermediate (ia-3) synthesized as above in 300 mL of acetonitrile, and the mixture was stirred at 23 °C for 3 hrs. Thereafter, the reaction liquid was transferred to a separatory funnel, and 300 mL of toluene was added thereto. A liquid separation operation was conducted to recover an aqueous layer (under layer). The recovered underlayer was charged back to the separatory funnel, and 200 mL of 3 N hydrochloric acid was added to adjust the pH to be 1. After 300 mL of toluene was added, a liquid separation operation was conducted to recover an organic layer (upper layer). The organic layer thus recovered was concentrated in vacuo with an evaporator to give a residue of 95.3 g. Thus resulting residue was transferred into a 1,000 mL three-neck flask in which nitrogen substitution had been executed, and 200 mL of toluene and 0.5 g of N,N-dimethylformamide were added thereto, followed by stirring with a stirrer. Thereto was added 54.4 g of oxalyl chloride dropwise over for 30 min, and the mixture was stirred for 2 hrs after the completion of the dropwise addition. Thereafter, the reaction liquid was concentrated in vacuo with an evaporator to distill unreacted oxalyl chloride away, and 100 mL of toluene was added thereto to obtain a reaction product solution (B). Next, into a 1,000 mL three-neck flask in which nitrogen substitution had been executed were added 200 mL of toluene, 42.9 g of 2,2,2-trifluoroethanol and 43.3 g of tiiethylamine, and the mixture was stirred with a stimer. The internal temperature was lowered to no greater than 5 °C on an ice bath. The resulting reaction product solution (B) was added dropwise over 1 hr, and stirring of the mixture was continued at 23 °C for 2 hrs after the completion of the dropwise addition. Thereafter, 400 mL of 1 N hydrochloric acid was added thereto, followed by stirring for 5 min, and the reaction liquid was transferred to a separatory funnel. A liquid separation operation was conducted to recover an organic layer (upper layer). Washing by liquid separation of the thus recovered organic layer was repeated five times with each 100 mL of pure water, and the organic layer was vacuum concentrated with an evaporator to give 105.2 g of a crude product. This crude product was vacuum distilled at 1 mmHg, 98 °C to obtain 85.1 g of a compound (i-3) (a compound represented by the following formula (i-3)) (yield: 69% (based on synthesis intermediate (ia-3))). Thus resultant compound (i-3) was analyzed by LC-MS, and consequently ascertained that M⁺ was 346.1.

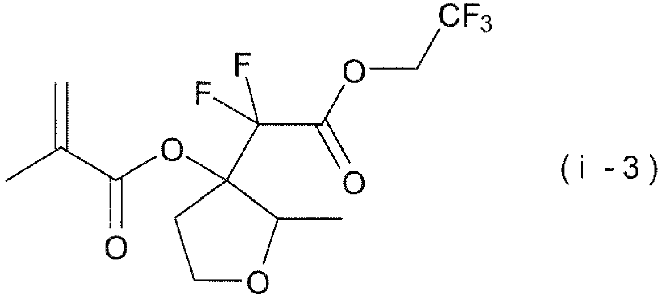

### Example 4: Synthesis of Compound (i-4)

A compound (i-4) (a compound represented by the following formula (i-4)) was synthesized in a similar manner to Example 3 except that: bromodifluoromethyl acetate was used in place of ethyl bromodifluorolacetate as a material in Example 3; methyl pyruvate was used in place of 2-methyltetrahydrofuran-3-one; and the vacuum distillation was carried out at 1 mmHg, 110 °C (yield: 51% (based on methyl bromofluoroacetate)). Thus resultant compound (i-4) was analyzed by LC-MS, and consequently ascertained that M⁺ was 348.1.

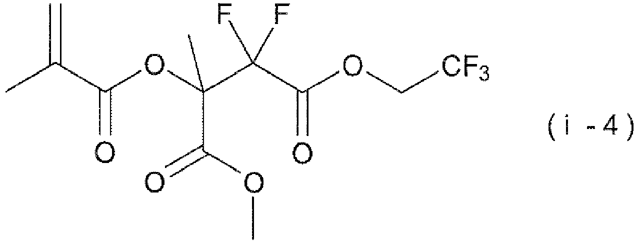

### Example 5: Synthesis of Compound (i-5)

A compound (i-5) (a compound represented by the following formula (i-5)) was synthesized in a similar manner to Example 3 except that: methoxyacetone was used in place of 2-methyltetrahydrofuran-3-one as a material in Example 3; and the vacuum distillation was carried out at 1 mmHg, 101 °C (yield: 46% (based on ethyl bromodifluorolacetate)). Thus resultant compound (i-5) was analyzed by LC-MS, and consequently ascertained that M⁺ was 334.1.

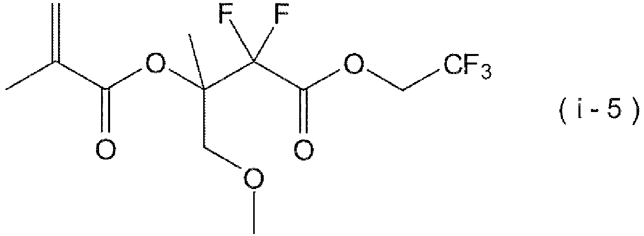

### Example 6: Synthesis of Compound (i-6)

A compound (i-6) (a compound represented by the following formula (i-6)) was synthesized in a similar manner to Example 3 except that: tetrahydrothiophene-3-one was used in place of 2-methyltetrahydrofuran-3-one as a material in Example 3; and the vacuum distillation was carried out at 1 mmHg, 106 °C (yield: 43% (based on ethyl bromodifluorolacetate)). Thus resultant compound (i-6) was analyzed by LC-MS, and consequently ascertained that M⁺ was 348.1.

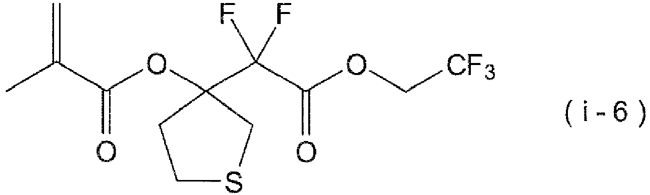

### Synthesis of Polymer

Each monomer used for the synthesis of the polymer (A) (water repellent polymer additive) and the polymer (C) (base polymer) is shown below.

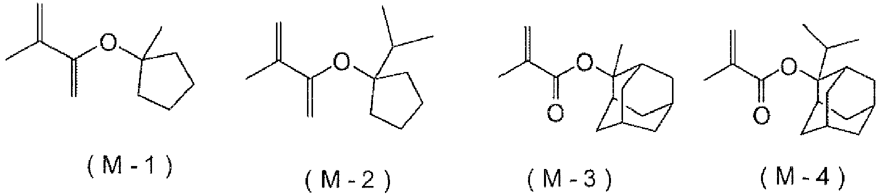

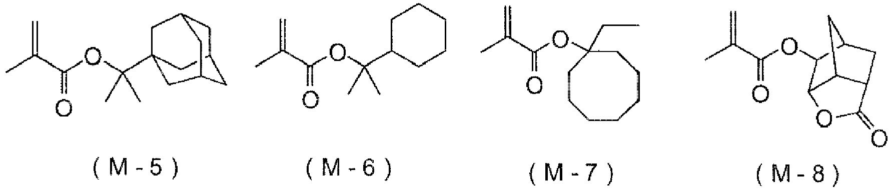

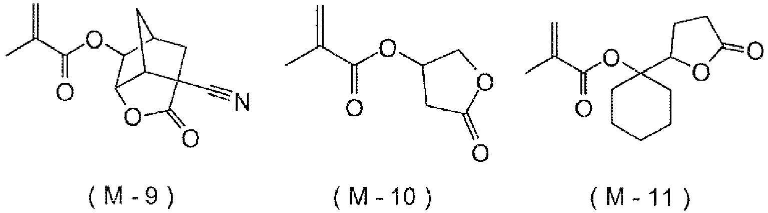

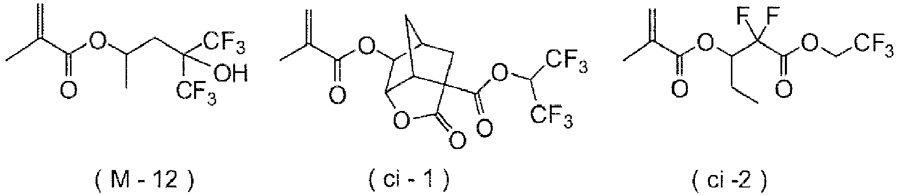

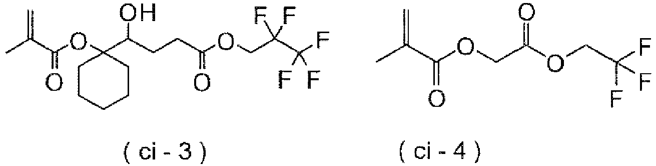

It is to be noted that: the compounds (i-1) to (i-6) give the structural unit (I) of the polymer (A); the compounds (M-1) to (M-7) give the structural unit (II) of the polymer (A), or the structural unit (C-I) of the polymer (C); the compounds (M-8) to (M-11) give the structural unit (C-II) of the polymer (C); and the compound (M-12) gives the structural unit (III) of the polymer (C).

### Synthesis of Polymer (A)

### Example 7

A monomer solution was prepared by dissolving 26.8 g (80 mol%) of the compound (i-1) and 3.2 g (20 mol%) of the compound (M-2) in 30 g of 2-butanone, and further dissolving therein 0.27 g of dimethyl 2,2'-azobisisobutyrate as a radical polymerization initiator. Next, a 300 mL three-neck flask containing 30 g of 2-butanone was purged with nitrogen for 30 min, then heated to 80 °C with stirring, and the monomer solution prepared above was added dropwise over 3 hrs using a dropping funnel. The time of the start of the dropwise addition was regarded as the time of the start of the polymerization reaction, and the polymerization reaction was allowed to proceed for 6 hrs. After the completion of the polymerization reaction, the polymerization reaction solution was water-cooled to 30 °C or below. After the cooled polymerization reaction solution was transferred to a 2 L separatory funnel, 450 g of n-hexane and 90 g of acetonitrile were charged and mixed, and then the mixture was left to stand for 30 min. Thereafter, the underlayer was recovered, and the solvent was replaced with propylene glycol monomethyl ether acetate to give a propylene glycol monomethyl ether acetate solution of a polymer (A-1) (yield: 88%). The polymer (A-1) had an Mw of 12,000, and the Mw/Mn of 1.66. The result of the ¹³C-NMR analysis indicated that the proportions of the structural unit derived from (i-1) and the compound (M-2) were 81.0 mol% and 19.0 mol%, respectively.

### Examples 8 to 13 and Synthesis Examples 1 to 4

Polymers (A-2) to (A-7) and (a-1) to (a-4) were obtained in a similar manner to Example 1 except that the type and and the using amount of each monomer used were as listed in the following Table 1. It is to be noted that "-" in Table 1 indicates that a corresponding monomer was not used. Note that the total mass of the monomers used was 30 g. The proportion (mol%) of each structural unit, the yield (%), the Mw and the Mw/Mn ratio of these polymers are shown together in Table 1.

**Table 1**

| | (A) Component | Structural unit (I) | | | Structural unit (II) | | | Structural unit (III) | | | Yield (%) | Mw | Mw/Mn |
|---|---|---|---|---|---|---|---|---|---|---|---|---|---|
| | | monomer type | using amount (mol%) | proportion of structural unit (mol%) | monomer type | using amount (mol%) | proportion of structural unit (mol%) | monomer type | using amount (mol%) | proportion of Structural unit (mol%) | | | |
| Example 7 | A-1 | i-1 | 80 | 81.0 | M-2 | 20 | 19.0 | - | - | - | 88 | 12.000 | 1.66 |
| Example 8 | A-2 | i-2 | 80 | 82.9 | M-7 | 20 | 17.1 | - | - | - | 93 | 21,500 | 2.11 |
| Example 9 | A-3 | i-2 | 30 | 29.0 | M-1 | 20 | 18.9 | - | - | - | 87 | 11,000 | 1.70 |
| | | i-3 | 50 | 52.1 | | | | | | | | | |
| Example 10 | A-4 | i-4 | 70 | 71.9 | M-4 | 30 | 28.1 | - | - | - | 90 82 | 23,000 | 2.20 |
| Example 11 | A-5 | i-5 | 70 | 70.9 | M-7 | 30 | 29.1 | - | - | - | 82 | 15,000 | 1.90 |
| Example 12 | A-6 | i-6 | 30 | 32.0 | M-5 | 20 | 18.1 | - | - | - | 88 | 10,000 | 1.50 |
| | | ci-4 | 50 | 49.9 | | | | | | | | | |
| Example 13 | A-7 | i-4 | 60 | 59.9 | M-1 | 20 | 19.7 | M-12 | 20 | 20.4 | 91 | 17,000 | 1.80 |
| Synthesis Example 1 | a-1 | ci-1 | 80 | 82.5 | M-6 | 20 | 17.5 | - | - | - | 77 | 20,500 | 1.90 |
| Synthesis Example 2 | a-2 | ci-2 | 70 | 70.2 | M-7 | 30 | 29.8 | - | - | - | 65 | 10,500 | 1.60 |
| Synthesis Example 3 | a-3 | ci-3 | 70 | 73.0 | M-7 | 30 | 27.0 | - | - | - | 97 | 19,000 | 2.30 |
| Synthesis Example 4 | a-4 | ci-4 | 75 | 74.5 | M-7 | 25 | 25.5 | - | - | - | 69 | 13,000 | 1.70 |

### Synthesis of polymer (C)

### Synthesis Example 5

A monomer solution was prepared by dissolving 51.0 g (55 mol%) of the compound (M-6) and 49.0 g (45 mol%) of the compound (M-9) in 150 g of 2-butanone, and further dissolving 3.62 g of AIBN (5 mol% with respect to the total number of moles of the compounds) as a radical polymerization initiator. Next, a 100 mL three-neck flask containing 50 g of 2-butanone was purged with nitrogen for 30 min, then heated to 80 °C with stirring, and the monomer solution prepared above was added dropwise over 3 hrs using a dropping funnel. The time of the start of the dropwise addition was regarded as the time of the start of the polymerization reaction, and the polymerization reaction was allowed to proceed for 6 hrs. After the completion of the polymerization reaction, the polymerization reaction solution was water-cooled to 30 °C or below. The cooled polymerization reaction solution was poured into 1,500 g of methanol, and a precipitated white powder was filtered off. The collected white powder was washed twice with 300 g of methanol, followed by filtration, and dried at 50 °C for 17 hrs, whereby 81 g of a polymer (C-1) was obtained as a white powder (yield: 81%). The polymer (C-1) had an Mw of 6,900 and the Mw/Mn of 1.55. In addition, the result of the ¹³C-NMR analysis indicated that the proportions of the structural unit derived from (M-6) and (M-9) were 53.3 mol% and 46.7 mol%, respectively.

### Synthesis Examples 6 and 7

Polymers (C-2) and (C-3) were synthesized in a similar manner to Synthesis Example 5 except that each monomer of the type and the using amount shown in the following Table 2 was used. It is to be noted that the total mass of the monomer used was 100 g. The proportion of each structural unit contained, yield (%), Mw and Mw/Mn ratio of these polymers are shown in Table 2 altogether.

**Table 2**

| | (C) Polymer | Structural unit (C-I) | | | Structural unit (C-II) | | | Yield (%) | Mw | Mw/Mn |
|---|---|---|---|---|---|---|---|---|---|---|
| | | monomer type | using amount (mol%) | proportion of structural unit (mol%) | monomer type | using amount (mol%) | proportion of structural unit (mol%) | | | |
| Synthesis Example 5 | C-1 | M-6 | 55 | 53.3 | M-9 | 45 | 46.7 | 81 | 6,900 | 1.55 |
| Synthesis Example 6 | C-2 | M-2 | 50 | 49.2 | M-8 | 40 | 41.7 | 80 | 5,500 | 1.55 |
| | | M-3 | 10 | 9-1 | | | | | | |
| Synthesis Example 7 | C-3 | M-1 | 40 | 39.0 | M-10 | 40 | 41.3 | 74 | 6,700 | 1.61 |
| | | | | | M-11 | 20 | 19.7 | | | |

### Preparation of Radiation-Sensitive Resin Composition

Each component used in preparing the radiation-sensitive resin composition is shown below.

### (B) Acid Generating Agent

Each structure formula is shown below.
B-1: triphenylsulfonium 3-hydroxyadamantan-1-ylmethyloxycarbonyl difluoromethanesulfonate
B-2: triphenylsulfonium adamantan-1-ylcarbonyloxy-1,1,3,3,3-pentafluoropropane-1-sulfonate
B-3: 4-butoxynaphthalen-1-yltetrahydrothiophenium 3-hydroxyadamantan-1-ylmethyloxycarbonyldifluoromethanesulfonate
B-4: triphenylsulfonium 2-(adamantan-1-yl)-1,1-difluoroethanesulfonate

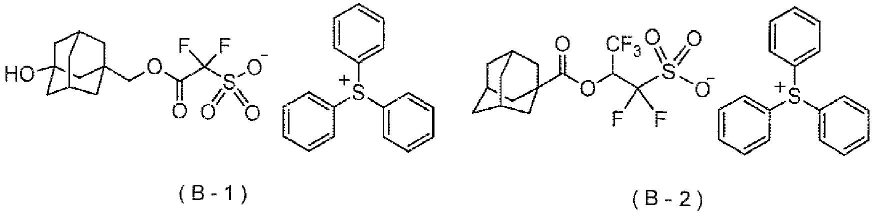

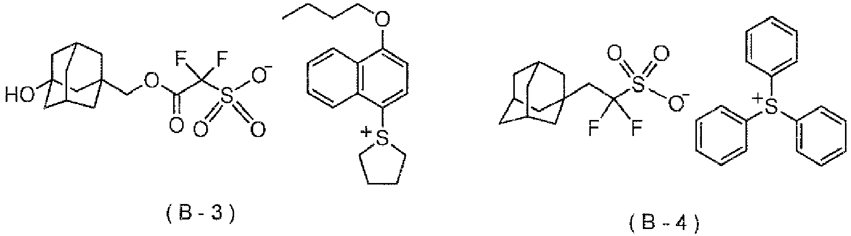

### (D) Acid Diffusion Control Agent

Each structure formula is shown below.
D-1: triphenylsulfonium 10-camphorsulfonate

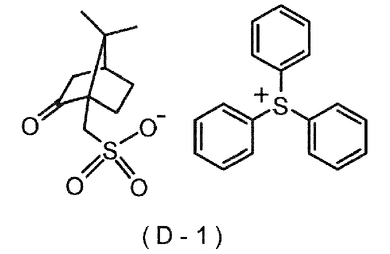

### (E) Solvent

E-1: propylene glycol monomethyl ether acetate
E-2: cyclohexanone
E-3: γ-butyrolactone

### Example 14

A radiation-sensitive resin composition (J-1) was prepared by mixing 5 parts by mass of (A-1) as the polymer (A), 100 parts by mass of (C-1) as the polymer (C), 5.1 parts by mass of (B-1) as the acid generating agent (B), 7.9 parts by mass of (D-1) as the acid diffusion control agent (D), and 1,980 parts by mass of (E-1), 850 parts by mass of (E-2) and 100 parts by mass of (E-3) as the solvent (E), and filtering of the obtained mixture through a membrane filter having a pore size of 0.2 µm.

### Examples 15 to 20 and Comparative Examples 1 to 4

Radiation-sensitive resin compositions (J-2) to (J-7) and (CJ-1) to (CJ-4) were prepared in a similar manner to Example 14 except that the type and the content of each component used were as listed in the following Table 2.

**Table 3**

| | Radiation-sensitive resin composition | (A) Component | | (B) Acid generating agent | | (C) Polymer | | (D) Acid Diffusion control agent | | (E) Solvent | |
|---|---|---|---|---|---|---|---|---|---|---|---|
| | | type | content (parts by mass) | type | content (parts by mass) | type | content (parts by mass) | type | content (parts by mass) | type | content (parts by mass) |
| Example 14 | J-1 | A-1 | 5 | B-1 | 5.1 | C-1 | 100 | D-1 | 7.9 | E-1/E-2/E-3 | 1,980/850,/100 |
| Example 15 | J-2 | A-2 | 5 | B-2 | 5.5 | C-1 | 100 | D-1 | 7.9 | E-1/E-2/E-3 | 1,980/850/100 |
| Example 16 | J-3 | A-3 | 4 | B-4 | 5.6 | C-2 | 100 | D-1 | 7.9 | R-1/E-2/F-3 | 1,980/85(/100 |
| Example 17 | J-4 | A-4 | 7 | B-1 | 5.1 | C-3 | 100 | D-1 | 7.9 | E-1/E-2/E-3 | 1,980/850/100 |
| Example 18 | J-5 | A-5 | 5 | B-1 | 5.1 | C-3 | 100 | D-1 | 7.9 | E-1/E-2/E-3 | 1,980/850/100 |
| Example 19 | J-6 | A-6 | 7 | B-1/B-3 | 3.6/4 | C-3 | 100 | D-1 | 7.9 | E-1/E-2/E-3 | 1,980/850/ 100 |
| Example 20 | J-7 | A-7 | 7 | B-1/B-3 | 3.6/4.0 | C-1 | 100 | D-1 | 7.9 | E-1/E-2/E-3 | 1,980/850/100 |
| Comparative Example 1 | CJ-1 | a-1 | 5 | B-1 | 5.1 | C-1 | 100 | D-1 | 7.9 | E-1/E-2/E-3 | 1,980/850/100 |
| Comparative Example | CJ-2 | a-2 | 5 | B-1 | 5.1 | C-1 | 100 | D-1 | 7.9 | E-1/E-2/E-3 | 1,980/850/100 |
| Comparative Example 3 | CJ-3 | a-3 | 7 | B-1 | 5.1 | C-1 | 100 | D-1 | 7.9 | E-1/E-2-E-3 | 1,980/850/100 |
| Comparative Example 4 | CJ-4 | a-4 | 7 | B-1 | 5.1 | C-1 | 100 | D-1 | 7.9 | E-1/E-2/E-3 | 1,980/850/100 |

### Formation of Resist Pattern

An underlayer antireflective film having a film thickness of 105 nm was provided on the surface of a 12-inch silicon wafer by applying a composition for underlayer antireflective film formation (Brewer Science Co., Ltd., "ARC66") on the surface of the 12-inch silicon wafer using a spin coater (Tokyo Electron Limited, "CLEAN TRACK ACT12"), and thereafter heating the same at 205 °C for 60 sec. Each radiation-sensitive resin composition was applied on the underlayer antireflective film using the spin coater, and subjected to PB at 100 °C for 50 sec. Thereafter, cooling was carried out at 23 °C for 30 sec to form a resist film having a film thickness of 90 nm. Next, the resist film was exposed using an ArF excimer laser Immersion Scanner (ASML, "TWINSCAN XT-1900i") through a 38 nm line-and-space (1L/1S) mask pattern for resist pattern formation, under optical conditions involving NA of 1.35 and Dipole 35X (σ = 0.97/0.77). After the exposure, PEB was carried out at each PEB temperature shown in Table 4 for 50 sec. Thereafter, a puddle development was carried out with a 2.38% by mass aqueous TMAH solution at 23 °C for 30 sec. Then, rinsing with ultra pure water for 7 sec followed by spin-drying at 2,000 rpm for 15 sec resulted in formation of a 38 nm line-and-space (1L/1S) resist pattern.

### Evaluations

Each radiation-sensitive resin composition was evaluated through determinations on the resist patterns formed as described above in accordance with the following methods. The results of the evaluations are shown in Table 4 below. It is to be noted that for the measurements on the resist pattern, a scanning electron microscope (Hitachi High-Technologies Corporation, "CG-4100") was used.

### Sensitivity

An exposure dose at which a 38 nm line-and-space (1L/1S) resist pattern was formed in the aforementioned formation of the resist pattern was determined as an optimum exposure dose (Eop), which was defined as sensitivity (mJ/cm²). The sensitivity may be evaluated to be: "favorable" in the case of being no greater than 30 mJ/cm²; and "unfavorable" in the case of exceeding 30 mJ/cm².

### LWR Performance

The resist pattern formed through an irradiation at the exposure dose of Eop determined as described above was observed by using the scanning electron microscope from above the pattern. Variance of the line widths was measured from 500 points in total, and a 3 Sigma value was determined from the distribution of the measurements. The 3 Sigma value was defined as LWR performance (nm). The smaller value is more favorable since a better LWR performance is indicated, revealing a less irregularity. The LWR performance may be evaluated to be: "favorable" in the case of being no greater than 2.5 nm; and "unfavorable" in the case of exceeding 2.5.

### CDU Performance

The resist pattern formed through an irradiation at the exposure dose of Eop determined as described above was observed by using the scanning electron microscope from above the pattern. The line widths were measured at 20 points within the range of 400 nm, and an averaged value of the widths was determined. The averaged value was determined at arbitrary points of 500 in total, and a 3 Sigma value was determined from the distribution of the measurements. The 3 Sigma value was defined as CDU performance (nm). The smaller value is more favorable since a better CDU performance is indicated, revealing a less variance of the line widths even in cases of sparse patterns. The CDU performance may be evaluated to be: "favorable" in the case of being no greater than 1.5 nm; and "unfavorable" in the case of exceeding 2.0.

### EL Performance

The EL performance of the radiation-sensitive resin composition was evaluated based on each value of 10% EL, Bridge limit and Collapse limit determined in accordance with the following methods.

### 10% EL

When a mask pattern for a 38 nm line-and-space (1L/1S) resist pattern formation was used, a range of the exposure dose in which the dimension of the resolved resist pattern fell within ±10% of the designed dimension of the mask was determined. A ratio of the range to the aforementioned Eop was defined as 10% EL (%). The greater 10% EL is more favorable since the degree of alteration of the patterning performance depending on the variation of the exposure dose is smaller. The 10% EL may be evaluated to be: "favorable" in the case of being no less than 18%; and "unfavorable" in the case of being less than 18%.

### Bridge Limit

A minimum pattern width accompanied by occurrence of a bridge as the exposure dose was decreased from the Eop in forming the resist pattern was determined as a bridge limit (nm), and this value was employed as a marker of the bridge limit. The greater value of the bridge limit is favorable since bridge defects are less likely to occur. The bridge limit may be evaluated to be: "favorable" in the case of being no less than 50 nm; and "unfavorable" in the case of being less than 50 nm.

### Collapse Limit

A minimum pattern width accompanied by occurrence of pattern collapse as the exposure dose was increased from the Eop in forming the resist pattern was determined as a collapse limit (nm), and this value was employed as a marker of the collapse limit. The smaller value of the collapse limit is favorable since collapse of the resist pattern is less likely to occur. The collapse limit may be evaluated to be: "favorable" in the case of being no greater than 28 nm; and "unfavorable" in the case of exceeding 28 nm.

### Inhibitory Ability of Defects

On a 12-inch silicon wafer having an underlayer antireflective film formed from a composition for underlayer antireflective film formation (Nissan Chemical Industries, Ltd., "ARC66"), a coating film was provided from the radiation-sensitive resin composition. SB was carried out at 120 °C for 50 sec to form a resist film having a thickness of 110 nm. Next, the resist film was exposed using an ArF excimer laser Immersion Scanner (Nikon Corporation, "NSR-S610C") through a mask pattern for forming line-and-space (1L/1S) with a target size of 40 nm in width, under optical conditions involving NA of 1.3, a ratio of 0.800, with Dipole. After the exposure, PEB was carried out at 95 °C for 50 sec. Thereafter, a development was carried out with a 2.38% by mass aqueous tetramethylammonium hydroxide solution for 10 sec by using a GP nozzle of a development apparatus (Tokyo Electron Limited, "CLEAN TRACK ACT12"). Then, rinsing with pure water for 15 sec followed by spin-drying at 2,000 rpm resulted in formation of a positive resist pattern. In this resist pattern formation, an exposure dose at which 1L/1S with a width of 38 nm was formed was defined as an optimum exposure dose. At this optimum exposure dose, 1L/1S with a line width of 38 nm was formed on the entire face of the wafer to give a wafer for defect inspection. It is to be noted that a scanning electron microscope (Hitachi High-Technologies Corporation, CG-4000) was used for a line-width measurement. The number of defects on the wafer for defect inspection was counted using a defect inspection apparatus (KLA-Tencor Corporation, "KLA2810"). Then, the counted defects were sorted to: those decided to be derived from the resist film; and those derived from unwanted foreign substance, and the number of the defects decided to be derived from the resist film was counted. The inhibitory ability of defects is more favorable as the number of the defects decided to be derived from the resist film is smaller. The inhibitory ability of defects may be evaluated to be: "favorable" in the case where the number of the defects decided to be derived from the resist film is no greater than 0.1/cm²; and "unfavorable" in the case of the number exceeding 0.1/cm².

**Table 4**

| | Radiation-sensitive resin composition | PEB temperature (°C) | Sensitivity (mJ/cm²) | LWR performance (nm) | CDU performance (nm) | EL performance | | | Detect inhibitory ability (number of defect/cm²) |
|---|---|---|---|---|---|---|---|---|---|
| | | | | | | 10% EL (%) | Bridge limit (nm) | Collapse limit (nm) | |
| Example 14 | J-1 | 95 | 28.4 | 2.2 | 1.1 | 23.3 | >55 | <25 | 0.01 |
| Example 15 | J-2 | 95 | 25.4 | 2.4 | 1.2 | 21.4 | >55 | <25 | 0.01 |
| Example 16 | J-3 | 85 | 29.1 | 2.3 | 1.2 | 20.0 | >55 | <25 | 0.01 |
| Example 17 | J-4 | 90 | 27.6 | 2.2 | 1.1 | 21.8 | >55 | <25 | 0.01 |
| Example 18 | J-5 | 90 | 28.0 | 2.1 | 1.1 | 18.9 | >5S | <25 | 0.01 |
| Example 19 | J-6 | 90 | 29.5 | 2.2 | 1.1 | 21.8 | >55 | <25 | 0.01 |
| Example 20 | J-7 | 95 | 25.9 | 2.1 | 1.3 | 22.8 | >55 | <25 | 0.01 |
| Comparative Example 1 | CJ-1 | 95 | 29.9 | 3.3 | 3.8 | 20.0 | 41 | 37 | 1.81 |
| Comparative Example 2 | CJ-2 | 95 | 28.9 | 3.0 | 2.9 | 20.5 | 43 | 33 | 1.77 |
| Comparative Example 3 | CJ-3 | 95 | 29.3 | 3.0 | 2.9 | 22.4 | 40 | 34 | 10.30 |
| Comparative Example 4 | CJ-4 | 95 | 29.4 | 3.3 | 2.8 | 21.4 | 40 | 30 | 8.22 |

As is clear from the results shown in Table 4, according to the radiation-sensitive resin compositions of Examples, a resist pattern having less LWR and CDU, and being accompanied by fewer defects can be formed while superior EL performances are exhibited. To the contrary, according to the radiation-sensitive resin compositions of Comparative Examples, each performance of the LWR performance, the CDU performance, the EL performance and the inhibitory ability of defects was insufficient.

### [INDUSTRIAL APPLICABILITY]

According to the radiation-sensitive resin composition and the resist pattern-forming method of the embodiments of the present invention, a resist pattern having less LWR and CDU, and being accompanied by fewer defects can be formed while superior EL performances are exhibited. The polymer according to the still another embodiment of the present invention can be suitably used as a polymer component the radiation-sensitive resin composition. The compound according to the yet another embodiment of the present invention can be suitably used as a monomer of the polymer. Therefore, these can be suitably used for manufacture of semiconductor devices in which further progress of miniaturization is expected in the future.

## Claims

1. A radiation-sensitive resin composition comprising:
a first polymer having a first structural unit represented by formula (1); and
a radiation-sensitive acid generator, 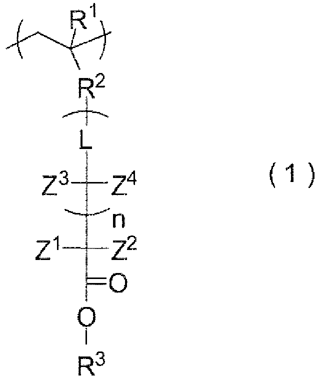
wherein, in the formula (1), R¹ represents a hydrogen atom, a fluorine atom, a methyl group or a trifluoromethyl group; R² represents a divalent linking group; Z¹ to Z⁴ each independently represent a hydrogen atom, a fluorine atom, a monovalent hydrocarbon group, a monovalent fluorinated hydrocarbon group, or a monovalent group that comprises a hetero atom having a valency of no less than 2; L represents a single bond or a divalent hydrocarbon group, wherein at least two of Z³, Z⁴ and L may taken together represent a ring structure (a) having 3 to 20 ring atoms together with the carbon atom to which the at least two of Z³, Z⁴ and L bond, and wherein at least two of Z¹ to Z⁴ and L may taken together represent a ring structure (b) having 3 to 8 ring atoms together with the carbon atom to which the at least two of Z¹ to Z⁴ and L bond; n is 0 or 1; and R³ represents a monovalent hydrocarbon group or a monovalent fluorinated hydrocarbon group, wherein at least any one of Z¹, Z² and R³ comprises a fluorine atom, and wherein at least any one of Z¹ to Z⁴, the ring structure (a) and the ring structure (b) comprises a hetero atom having a valency of no less than 2, and in a case in which R² represents -COO- and n is 0, both Z¹ and Z² do not represent an alkoxy group.

2. The radiation-sensitive resin composition according to claim 1, wherein the hetero atom having a valency of no less than 2 is an oxygen atom, a nitrogen atom, a sulfur atom, a phosphorus atom, a silicon atom or a combination thereof.

3. The radiation-sensitive resin composition according to claim 1, wherein the first polymer further comprises a second structural unit represented by formula (2): 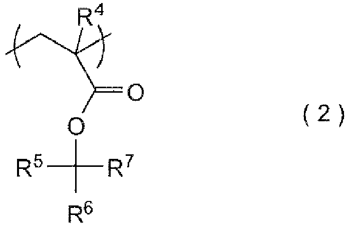 wherein, in the formula (2), R⁴ represents a hydrogen atom, a fluorine atom, a methyl group or a trifluoromethyl group; R⁵ represents a monovalent chain hydrocarbon group having 1 to 10 carbon atoms or a monovalent alicyclic hydrocarbon group having 3 to 20 carbon atoms; R⁶ and R⁷ each independently represent a monovalent chain hydrocarbon group having 1 to 10 carbon atoms or a monovalent alicyclic hydrocarbon group having 3 to 20 carbon atoms, or R⁶ and R⁷ taken together represent an alicyclic structure having 3 to 20 carbon atoms together with the carbon atom to which R⁶ and R⁷ bond.

4. The radiation-sensitive resin composition according to claim 1, further comprising a second polymer that differs from the first polymer, wherein the second polymer comprises an acid-labile group-containing structural unit.

5. The radiation-sensitive resin composition according to claim 4, wherein the second polymer further comprises a structural unit comprising a lactone structure, a cyclic carbonate structure, a sultone structure or a combination thereof.

6. The radiation-sensitive resin composition according to claim 1, wherein the radiation-sensitive acid generator comprises a compound represented by formula (3):
R¹¹-R¹²-SO₃⁻ X⁺ (3)
wherein, in the formula (3), R¹¹ represents a monovalent group comprising an alicyclic structure having no less than 7 ring atoms or a monovalent group comprising an aliphatic heterocyclic structure having no less than 7 ring atoms; R¹² represents a fluorinated alkanediyl group having 1 to 10 carbon atoms; and X⁺ represents a monovalent radioactive ray-labile onium cation.

7. A resist pattern-forming method comprising:
forming a resist film;
subjecting the resist film to liquid immersion lithography; and
developing the resist film subjected to the liquid immersion lithography,
wherein the resist film is formed from the radiation-sensitive resin composition according to claim 1.

8. A polymer comprising a structural unit represented by formula (1): 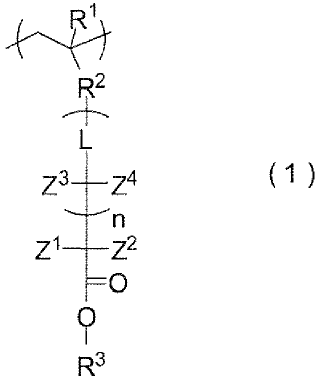 wherein, in the formula (1), R¹ represents a hydrogen atom, a fluorine atom, a methyl group or a trifluoromethyl group; R² represents a divalent linking group; Z¹ to Z⁴ each independently represent a hydrogen atom, a fluorine atom, a monovalent hydrocarbon group, a monovalent fluorinated hydrocarbon group, or a monovalent group that comprises a hetero atom having a valency of no less than 2; L represents a single bond or a divalent hydrocarbon group, wherein at least two of Z³, Z⁴ and L may taken together represent a ring structure (a) having 3 to 20 ring atoms together with the carbon atom to which the at least two of Z³, Z⁴ and L bond, and wherein at least two of Z¹ to Z⁴ and L may taken together represent a ring structure (b) having 3 to 8 ring atoms together with the carbon atom to which the at least two of Z¹ to Z⁴ and L bond; n is 0 or 1; and R³ represents a monovalent hydrocarbon group or a monovalent fluorinated hydrocarbon group, wherein at least any one of Z¹, Z² and R³ comprises a fluorine atom, and wherein at least any one of Z¹ to Z⁴, the ring structure (a) and the ring structure (b) comprises a hetero atom having a valency of no less than 2, and in a case in which R² represents -COO- and n is 0, both Z¹ and Z² do not represent an alkoxy group.

9. A compound represented by formula (i). 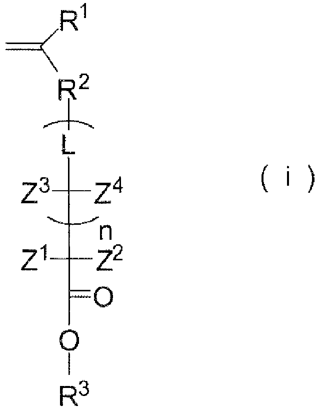 wherein, in the formula (i), R¹ represents a hydrogen atom, a fluorine atom, a methyl group or a trifluoromethyl group; R² represents a divalent linking group; Z¹ to Z⁴ each independently represent a hydrogen atom, a fluorine atom, a monovalent hydrocarbon group, a monovalent fluorinated hydrocarbon group, or a monovalent group that comprises a hetero atom having a valency of no less than 2; L represents a single bond or a divalent hydrocarbon group, wherein at least two of Z³, Z⁴ and L may taken together represent a ring structure (a) having 3 to 20 ring atoms together with the carbon atom to which the at least two of Z³, Z⁴ and L bond, and wherein at least two of Z¹ to Z⁴ and L may taken together represent a ring structure (b) having 3 to 8 ring atoms together with the carbon atom to which the at least two of Z¹ to Z⁴ and L bond; n is 0 or 1; and R³ represents a monovalent hydrocarbon group or a monovalent fluorinated hydrocarbon group, wherein at least any one of Z¹, Z² and R³ comprises a fluorine atom, and wherein at least any one of Z¹ to Z⁴, the ring structure (a) and the ring structure (b) comprises a hetero atom having a valency of no less than 2, and in a case in which R² represents -COO- and n is 0, both Z¹ and Z² do not represent an alkoxy group.
